(19) Europäisches Patentamt
European Patent Office
Office européen des brevets

(11) EP 4 387 429 A1

(12) **EUROPEAN PATENT APPLICATION**
published in accordance with Art. 153(4) EPC

(43) Date of publication:
**19.06.2024 Bulletin 2024/25**

(21) Application number: **22856018.1**

(22) Date of filing: **07.07.2022**

(51) International Patent Classification (IPC):
***H10K 99/00*** *(2023.01)* ***H10K 50/00*** *(2023.01)*

(52) Cooperative Patent Classification (CPC):
**H10K 30/50; C09K 11/00; H10K 85/342; H10K 85/346; H10K 85/615; H10K 85/654; H10K 85/6572; H10K 85/658;** H01L 33/502; H10K 59/38; H10K 85/626; H10K 85/633; H10K 85/657; H10K 2101/30; H10K 2101/40;

(Cont.)

(86) International application number:
**PCT/KR2022/009856**

(87) International publication number:
**WO 2023/018016 (16.02.2023 Gazette 2023/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.08.2021 KR 20210105286**
**06.07.2022 KR 20220082955**

(71) Applicant: **Lordin Co., Ltd**
**Hwaseong-si, Gyeonggi-do 18469 (KR)**

(72) Inventors:
- **PARK, Bubae**
**Seoul 07020 (KR)**
- **KIM, Youngjoon**
**Hwaseong-si, Gyeonggi-do 18469 (KR)**
- **MUN, Minsik**
**Hwaseong-si, Gyeonggi-do 18466 (KR)**

(74) Representative: **Pfenning, Meinig & Partner mbB**
**Patent- und Rechtsanwälte**
**Theresienhöhe 11a**
**80339 München (DE)**

(54) **HIGH-EFFICIENCY ENERGY DOWN-CONVERSION SYSTEM**

(57) The present disclosure provides an energy down conversion system that receives energy from the outside and converts it into low energy, including a multifunctional emitting compound.

[Fig. 3]

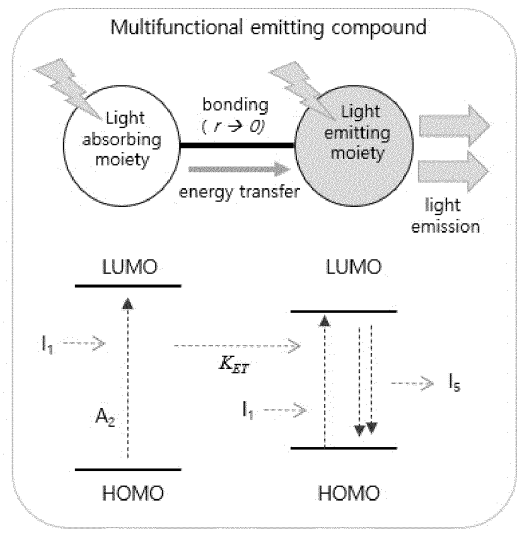


EP 4 387 429 A1

(52) Cooperative Patent Classification (CPC): (Cont.)
Y02E 10/549

## Description

[Technical Field]

The present disclosure relates to a high efficiency energy down conversion system capable of high efficiency light conversion and its application.

[Background Art]

Methods for obtaining blue, green, red, and near infrared ray energy in organic or inorganic LEDs include a self-luminescence method and an energy down conversion method. The self-luminescence method obtains blue, green, red and nearz infrared energy by adjusting the band gap energy of an emission layer material, and the energy down conversion method allows a high energy light source to pass through a light conversion medium to obtain blue, green, red and near infrared energy. Small displays in which pixelation with a shadow metal mask is easily applied adopt the self-luminescence method, and ultra-small displays such as AR and VR, or large area displays in which it is difficult to apply a shadow metal mask adopt the energy down conversion method.

[Disclosure]

[Technical Problem]

An object of the present disclosure is to provide an energy down conversion system that increases energy conversion efficiency by minimizing energy loss while increasing energy absorption.

The objectives of the present disclosure are not limited to the above mentioned objectives, and other unmentioned objectives and advantages of the present disclosure may be understood by the following description, and will be more clearly understood by the embodiments of the present disclosure. In addition, it will be readily apparent that the objectives and advantages of the present disclosure can be realized by means and combinations thereof set forth in the claims.

[Technical Solution]

One of more embodiments provide an energy down conversion system that receives energy from outside and converts it into low energy,

wherein the system comprises a multifunctional emitting compound;
the multifunctional emitting compound includes a light emitting moiety and a light absorbing moiety;
the light absorbing moiety absorbs energy and transfers it to the light emitting moiety;
Formula 1 below is satisfied, in which a HOMO energy of the light absorbing moiety is $E(1)_{HOMO}$, a LUMO energy of the light absorbing moiety is $E(1)_{LUMO}$, a HOMO energy of the light emitting moiety is $E(2)_{HOMO}$, and a LUMO energy of the light emitting moiety is $E(2)_{LUMO}$;

< Formula 1 >

$$\left| E(1)_{HOMO} - E(1)_{LUMO} \right| \geq \left| E(2)_{HOMO} - E(2)_{LUMO} \right|$$

Formula 2 below is satisfied when a wavelength of the light emitting moiety is greater than or equal to 350 nm and less than 2500 nm, in which an amount of light absorbed by the light emitting moiety is I(A), an amount of light emitted by the light emitting moiety is I(E), an amount of light absorbed by the light absorbing moiety is N(1), and an amount of light transferred to and emitted at the light emitting moiety is N(2); and

< Formula 2 >

$$0.2 \times [I(E) \div I(A)] \leq N(2)/N(1)$$

in the multifunctional emitting compound, the light emitting moiety and the light absorbing moiety are chemically connected so that a shortest distance between the moieties is within 10 Å.

[Advantageous Effects]

The energy down conversion system improves energy conversion efficiency by minimizing energy loss while increasing energy absorption.

[Description of Drawings]

Fig. 1 schematically shows the absorption-emission mechanism of a light emitting compound.
Fig. 2 schematically shows an absorption-emission mechanism in a state in which a light absorbing compound and a light emitting compound are mixed.
FIG. 3 schematically shows the absorption-emission mechanism of the multifunctional emitting compound in which the light absorbing moiety derived from a light absorbing compound and the light emitting moiety derived from a light emitting compound are connected.
Fig. 4 schematically shows the absorption-emission mechanism of Compound 1-1, Compound 1-2, and Compound 1-3.
Fig. 5 schematically shows the absorption-emission mechanism of Compound 2-1, Compound 2-2, and Compound 2-3.
Fig. 6 schematically shows the absorption-emission mechanism of Compound 3-1, Compound 3-2, and Compound 3-3.
Fig. 7 schematically shows the absorption-emission mechanism of Compound 3-4.
Fig. 8 is the absorption spectrum and the emission spectrum measured for the mixture of Compound 1-1 and Compound 1-2.
Fig. 9 shows the absorption spectrum and the emission spectrum measured for Compound 1-1, Compound1-2 and Compound1-3.
Fig. 10 shows the absorption spectrum and the emission spectrum measured for Compound 2-1, Compound 2-2 and Compound 2-3.
Fig. 11 shows the absorption spectrum and the emission spectrum measured for Compound 3-1, Compound 3-2 and Compound 3-3.
Fig. 12 shows the absorption spectrum and the emission spectrum measured for Compound 3-3 and Compound 3-4.
Fig. 13 is the emission spectrum measured for the films prepared in Comparative Example 2 and Example 5, respectively.

[Best Mode]

Hereinafter, embodiments of the present disclosure will be described in detail in such a manner that the disclosure may be easily carried out by those skilled in the art to which the present disclosure pertains. The present disclosure may exist as different embodiments and should not be construed as being limited to the ones set forth herein.
As used herein, the term "substitution" means that a hydrogen atom bonded to a carbon atom in a compound is substituted with another substituent. The position where substitution occurs means the position where a hydrogen atom is substituted. The position is not limited as long as hydrogen at the position can be substituted with a substituent. When two or more substitutions occur, the two or more substituents may be the same or different.
As used herein, a substituent in the case of being "substituted" may be one selected from the group consisting of, for example, deuterium, an alkyl group having 1 to 20 carbon atoms, an alkoxy group having 1 to 20 carbon atoms, a halogen, a cyano group, a carboxy group, a carbonyl group, an amine group, and an alkylamine group having 1 to 20 carbon atoms, a nitro group, an alkylsilyl group having 1 to 20 carbon atoms, an alkoxysilyl group having 1 to 20 carbon atoms, a cycloalkyl silyl group having 3 to 30 carbon atoms, an arylsilyl group having 6 to 30 carbon atoms, an aryl group having 6 to 30 carbon atoms, an arylamine group having 6 to 30 carbon atoms, a heteroaryl group having 5 to 30 carbon atoms, an aryl phosphine oxide group having 6 to 30 carbon atoms, an aryl phosphinyl group having 6 to 30 carbon atoms, an alkyl phosphine oxide group having 6 to 30 carbon atoms, an alkylsulfonyl group having 6 to 30 carbon atoms and their combinations, but is not limited thereto.
An energy down conversion system according to one embodiment of the present disclosure receives energy from the outside and converts it into low energy,

the system comprises a multifunctional emitting compound,
the multifunctional emitting compound includes a light emitting moiety and a light absorbing moiety,
the light absorbing moiety absorbs energy and transfers it to the light emitting moiety,

Formula 1 below is satisfied, in which the HOMO energy of the light absorbing moiety is $E(1)_{HOMO}$, the LUMO energy of the light absorbing moiety is $E(1)_{LUMO}$, the HOMO energy of the light emitting moiety is $E(2)_{HOMO}$, and the LUMO energy of the light emitting moiety is $E(2)_{LUMO}$,

< Formula 1 >

$$\left| E(1)_{HOMO} - E(1)_{LUMO} \right| \geq \left| E(2)_{HOMO} - E(2)_{LUMO} \right|$$

Formula 2 below is satisfied when the wavelength of the light emitting moiety is greater than or equal to 350 nm and less than 2500 nm, in which the amount of light absorbed by the light emitting moiety is I(A), the amount of light emitted by the light emitting moiety is I(E), the amount of light absorbed by the light absorbing moiety is N(1), and the amount of light transferred to and emitted at the light emitting moiety is N(2), and

< Formula 2 >

$$0.2 \times [I(E) \div I(A)] \leq N(2)/N(1)$$

in the multifunctional emitting compound, the light emitting moiety and the light absorbing moiety are chemically connected so that the shortest distance between the moieties is within 10 Å.

One embodiment provides an energy down conversion system in which the light emitting moiety and the light absorbing moiety in the multifunctional emitting compound are connected through a chemical bond.

The light absorbing moiety functions to absorb energy applied from the outside, such as a light source. The connection portion by the chemical bond functions as a passage through which energy is transferred from the light absorbing moiety to the light emitting moiety. The light emitting moiety functions not only to absorb energy applied from the outside, but also to re-radiate the energy received from the light absorbing moiety.

The energy down conversion system refers to a light converting (energy down conversion) system that absorbs high energy and emits light of low energy. The energy down conversion system can increase energy conversion efficiency by minimizing energy loss while increasing energy absorption.

The light conversion method of the energy down conversion system can be widely used in areas such as displays, lightings, medical cares, and solar cells.

The energy down conversion system improves light conversion efficiency by using the multifunctional emitting compound capable of increasing a rate constant value related to the energy transfer rate.

Conventional energy down conversion systems use a light emitting compound alone or in a mixture with a polymer compound. When a light emitting compound is used alone, it is common to mix it with a high molecular (or low molecular) compound with the very high bandgap energy and keep a distance between the light emitting compounds in order to avoid the problem of reduced quantum efficiency and long wavelength shift due to the concentration quenching phenomenon.

The light conversion efficiency (Formula 3) of such an energy down conversion system is generally proportional to quantum efficiency of a light emitting compound and light absorbance of the system.

Light Conversion Efficiency $\propto$ Light Absorbance of Energy Down Conversion System $\times$ Quantum Efficiency of Light Emitting Compound <Formula 3 >

In Formula 3, quantum efficiency of a light emitting compound is calculated by Equation 4 below.

Quantum Efficiency of Light Emitting Compound = (Amount of Light emitted/Amount of Light absorbed) <Formula 4 >

Since quantum efficiency of a light emitting compound is a material specific value, light conversion efficiency varies depending on constitution and structure of a system. For example, if the concentration of a light emitting compound is increased, light absorbance is increased, but light conversion efficiency may be reduced due to the concentration quenching phenomenon. If the concentration of the light emitting compound is decreased and the thickness of the thin film is increased, light leakage may occur when a fine pixel structure is applied.

The energy down conversion system to which the multifunctional emitting compound is applied can increase

light absorbance while minimizing the concentration quenching phenomenon by increasing light conversion efficiency.

The multifunctional emitting compound is formed by connecting the light absorbing moiety and the light emitting moiety through the chemical bond. The multifunctional emitting compound satisfies the condition of Formula 1 and Formula 2 when the wavelength of the light emitting moiety is greater than or equal to 350 nm and less than 2500 nm, and the light emitting moiety and the light absorbing moiety are chemically bonded so that the shortest distance between the moieties is formed within 10 Å, and thus, the energy absorbed by the light absorbing moiety is transferred to the light emitting moiety.

The HOMO energy of a compound or a moiety can be measured with methods such as Cyclic Voltammetry (CV), Ultraviolet Photoelectron Spectroscopy (UPS), AC2, etc. A value measured by UV absorption spectrum or Cyclic Voltammetry (CV) can be applied to obtain the LUMO energy. In addition, quantum efficiency of the materials as used herein can be obtained by measurements in dissolving the emitting materials in a solution, filming by co-evaporation with a host material, or dissolving the host material and the emitting material in a solution at the same time, followed by spin coating or casting to form a film.

In the multifunctional emitting compound, the light absorbing moiety and the light emitting moiety may be connected via a linking group, the light absorbing moiety and the light emitting moiety may be directly connected without a linking group, or the light absorbing moiety and the light emitting moiety may form a spiro connection that shares an atom capable of forming a spiro connection.

For example, the chemical bond between the light emitting moiety and the light absorbing moiety may include a single bond, a double bond, a triple bond or a coordinate bond.

When the light absorbing moiety and the light emitting moiety are directly connected, a carbon atom in the light absorbing moiety and a carbon atom in the light emitting moiety are directly connected.

When the light absorbing moiety and the light emitting moiety are connected via a linking group, the linking group may include a substituted phenylene group; a substituted or unsubstituted arylene having 6 to 20 carbon atoms or heteroarylene having 5 to 20 carbon atoms, and the substituent when the phenylene group, the arylene and the heteroarylene are substituted is at least one selected from the group consisting of deuterium, an alkyl group having 1 to 20 carbon atoms, an alkoxy group having 1 to 20 carbon atoms, a halogen, a cyano group, a carboxy group, a carbonyl group, an amine group, an alkyl amine group having 1 to 20 carbon atoms, a nitro group, an alkylsilyl group having 1 to 20 carbon atoms, an alkoxysilyl group having 1 to 20 carbon atoms, cycloalkylsilyl group having 3 to 30 carbon atoms, arylsilyl group having 6 to 30 carbon atoms, aryl group having 6 to 30 carbon atoms, arylamine group having 6 to 30 carbon atoms, heteroaryl group having 5 to 30 carbon atoms, arylphosphine oxide group having 6 to 30 carbon atoms, an aryl phosphinyl group having 6 to 30 carbon atoms, an alkylphosphine oxide group having 6 to 30 carbon atoms, and an alkylsulfonyl group having 6 to 30 carbon atoms and combinations thereof; or the linking group may be a carbon atom, an oxygen atom, a nitrogen atom, a silicon atom, a Ge atom, an S atom, or a P atom, and when the linking group is the atom, a substituent selected from hydrogen, an alkyl having 1 to 20 carbon atoms, an aryl having 6 to 20 carbon atoms, a heteroaryl having 5 to 20 carbon atoms and combinations thereof may be included.

When the light absorbing moiety and the light emitting moiety form a spiro connection that shares an atom capable of forming a spiro connection, the spiro connection may connect using carbon, silicon, or Ge as a spiro atom.

In one embodiment, the linking group is a conjugated structure such that the shortest distance between the light absorbing moiety and the light emitting moiety is within 10 Å, and the bandgap energy of the conjugated structure is greater than that of the light absorbing moiety.

For example, the multifunctional emitting compound can be formed by chemically bonding the light absorbing compound and the light emitting compound. As a result, the light absorbing moiety originates from the light absorbing compound and the light emitting moiety originates from the light emitting compound. When the light absorbing compound and the light emitting compound are chemically bonded, the light absorbing moiety and the light emitting moiety may be derived with a substituent or the like appropriately being modified.

A chemical connection between the light absorbing moiety and the light emitting moiety should be formed so as not to significantly affect the electronic state of each of the light absorbing moiety and the light emitting moiety. As used herein, "not to significantly affect" means that one moiety should not change the HOMO energy level, LUMO energy level, or HOMO-LUMO bandgap energy of the other moiety by more than 0.2 eV. In addition, an excited complex should not be formed between the light absorbing moiety and the light emitting moiety.

In the multifunctional emitting compound, the criterion for defining the electronic state of each moiety may be an independent compound state as a compound in which each moiety and a linking portion are separated by hydrogen substitution without including a connecting portion. For example, when connected in a spiro structure, it can be compared with an independent compound state where each moiety connected in a spiro structure has been separated while being substituted with 2 hydrogens. At this time, the change in the degree of conjugation of each compound due to the connection portion and the change in the electronic state accordingly result from the connection or the linking group, and are not regarded as being affected by the counter moiety.

In one embodiment, the multifunctional emitting compound includes at least one light emitting moiety and at

least one light absorbing moiety, and a combination of the light emitting moiety and the light absorbing moiety may be connected in a spiro connection.

For example, the multifunctional emitting compound may include a first light absorbing moiety, a second light absorbing moiety, and a light emitting moiety, and the detailed descriptions of the first light absorbing moiety and the second light absorbing moiety are the same as in the light absorbing moiety, and they may be the same or different from each other. For example, the first light absorbing moiety may be connected to the light emitting moiety, and the second light absorbing moiety may be connected to the light emitting moiety or the first light absorbing moiety.

In one embodiment, the multifunctional emitting compound includes at least two light emitting moieties and at least two light absorbing moieties, and the light emitting moieties and the light absorbing moieties may be connected in a spiro connection by turns.

In the multifunctional emitting compound, at least one hydrogen atom may be substituted with deuterium. The energy down conversion system including the multifunctional emitting compound having a deuterium substituent may have improved material stability.

Fig. 1 schematically shows the absorption-emission mechanism of a light emitting compound. In FIG. 1, it is shown that the energy ($I_1$) applied from the outside is absorbed by the electrons in the HOMO of the light emitting compound in proportion to absorbance ($A_1$), transferred to the LUMO, and the energy ($I_2$) is re-emitted in proportion to quantum efficiency ($Q_1$), which is a conventional absorption-emission mechanism.

Fig. 2 schematically shows an absorption-emission mechanism in a state in which a light absorbing compound and a light emitting compound are mixed. FIG. 2 is a case where the light absorbing compound exists independently of the light emitting compound. The light absorbing compound absorbs the energy ($I_1$) (proportional to absorbance ($A_2$) of the light absorbing compound) and re-emits the energy ($I_3$) (proportional to quantum efficiency ($Q_2$) of the light absorbing compound) by the same operating mechanism as in the light emitting compound of FIG. 1, and, at this time, the light emitting compound absorbs the energy ($I_3$) emitted from the light absorbing compound in addition to the energy ($I_1$) applied from the outside, and then emits the energy ($I_4$). The emitted energy ($I_4$) is always greater than the emitted energy ($I_2$) when the light emitting compound exists alone. At this time, the amount of energy ($I_4$) is determined by energy transfer efficiency from the light absorbing compound to the light emitting compound.

Energy transfer methods include a method by light in Equation 1 below (FRET, Förster Resonance Energy transfer) and a method by electrons in Equation 2 below (Dexter Electron Transfer).

FRET (Förster Resonance Energy transfer)

[Equation 1]

$$k_{ET} = (\frac{1}{r^6 \tau_D})(\frac{2.07\kappa^2 Q_D J}{128\pi^5 N_A n^4})$$

Dexter Electron Transfer

[Equation 2]

$$k_{ET} \propto J exp^{(-\frac{2r}{L})}$$

$k_{ET}$ : rate constant
r : distance between an energy donor and an energy acceptor
$T_D$ : PL decay time of an energy donor
K : orientation factor
$Q_D$ : PL quantum efficiency of an energy donor
$N_A$ : Avogadro's number
n : refractive index
J : defined as Equation 3 as below.

[Equation 3]

$$J = \int f_D(\lambda)\varepsilon_A(\lambda)\,\lambda^4 d\lambda$$

$f_D$ : emission spectrum of an energy donor

$\varepsilon_A$ : extinction coefficient according to the wavelength of an energy donor

L : the sum of Van der Waals radii

$\lambda$ : wavelength

Whether the energy transfer method is the method for light following Equation 1 or the method for electrons following Equation 2, it is the distance (r) between the energy donor and the energy acceptor that is meaningful. In Equation 1 of energy transfer by light, when the distance (r) approaches 0, quantum efficiency and the decay time of the energy donor (a light absorbing compound) become insignificant, and the theoretical energy transfer rate approaches infinity. On the other hand, in Equation 2 of the energy transfer method by electron transfer, when the distance (r) between the two materials approaches 0, the energy transfer rate is only affected by the degree of overlap (J) between the emission spectra and absorption spectra between the two materials.

FIG. 3 schematically shows the absorption-emission mechanism of the multifunctional emitting compound in which the light absorbing moiety derived from a light absorbing compound and the light emitting moiety derived from a light emitting compound are combined. In FIG. 3, the multifunctional emitting compound includes the light absorbing moiety and the light emitting moiety in one molecule. Since the two moieties are connected while having little effect on the respective electronic energy state, the light absorption and emission characteristics do not change significantly compared to the case where each moiety exists as an independent compound before being connected. The energy absorbed by the light absorbing moiety is rapidly transferred to the light emitting moiety, and the light emitting moiety emits light through its electronic energy state, so that the emitted energy $I_5$ is greater than $I_2$ in FIG. 1 and $I_4$ in FIG. 2.

The light emitting moiety may be derived from a light emitting material capable of emitting light by absorbing energy applied from the outside (referred to herein as a light emitting compound).

The light emitting compound (a light emitting material) may be commonly selected according to the desired light emitting wavelength range according to the purpose, and the light emitting moiety may be derived therefrom.

In one embodiment, the light emitting moiety may have a conjugated structure having a quantum efficiency of 10% or more in a visible light wavelength range of 400 nm to 650 nm.

In one embodiment, the light emitting moiety may have a conjugated structure having a quantum efficiency of 0.5% or more in the 650 nm to 2500 nm near infrared wavelength region.

Specific examples of the light emitting compound (or the light emitting material) may be the following compounds, but are not limited thereto.

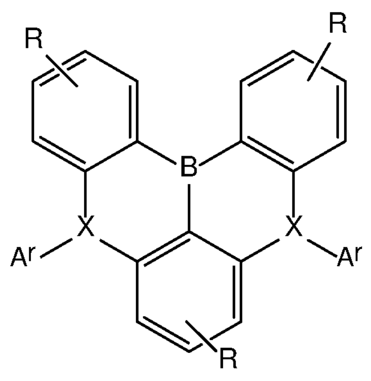

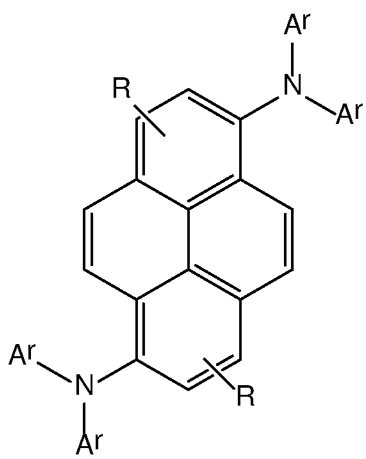

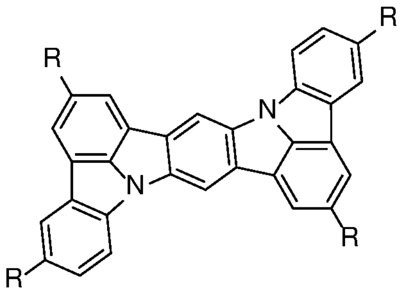

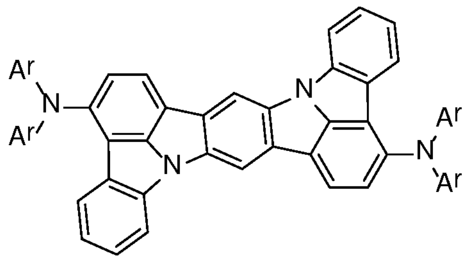

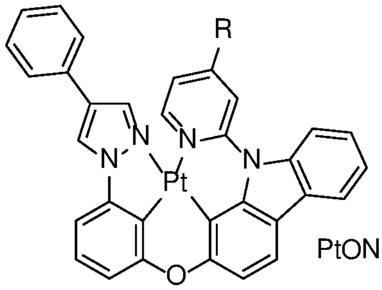

PtON6-tBu

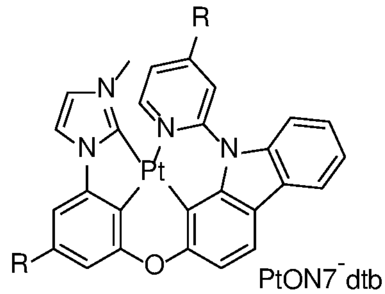

PtON7-dtb

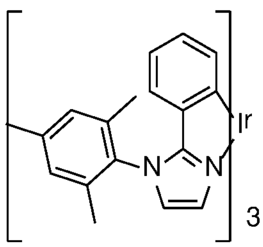

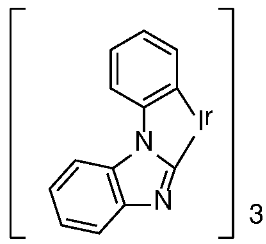

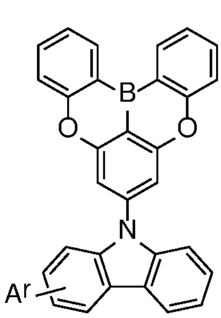

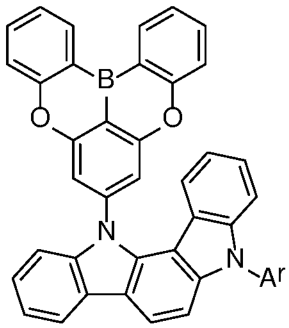

In the above formulae, Ar and R are, respectively, substituted or unsubstituted alkyl having 1 to 20 carbon atoms, substituted or unsubstituted aryl having 6 to 30 carbon atoms, substituted or unsubstituted heteroaryl having 5 to 30 carbon atoms, or substituted or unsubstituted aryl amine having 6 to 30 carbon atoms, and X is an element of nitrogen, oxygen, sulfur, carbon, silicon, Ge or P.

As described above, the light emitting compound may be a boron compound in which nitrogen, oxygen, sulfur, carbon, silicon, Ge, P, etc. are substituted, a pyrene compound, a compound having a conjugated structure containing nitrogen, and the like, as such in the above structural formulae, but is not limited thereto.

Further, for the light emitting compounds, the materials known as light emitting materials may be used. For example, the light emitting compounds has the conjugated structures such as anthracene, perylene, tetracene, chrysene, coumarine, pyromethene, etc.

In one embodiment, the light emitting compound and the light emitting moiety may have a conjugated structure including boron.

In one embodiment, the light emitting compound and the light emitting moiety may contain a metal.

The light emitting mechanism of the light emitting moiety may include fluorescence emitting light from a singlet,

phosphorescence emitting light from a triplet, and thermally activated delayed fluorescence emitting light when energy is transferred from a triplet to a singlet.

The bandgap energy of the light absorbing moiety may have the band gap energy 0.5 eV to 4.7 eV and the light emitting moiety may have the band gap energy of 0.5 eV to 3.5 eV.

In one embodiment, the difference in the bandgap energies between the light absorbing moiety and the light emitting moiety may be 4eV or less.

The light emitting moiety may be derived from a light emitting material capable of emitting light by absorbing energy applied from the outside (referred to herein as a light emitting compound).

The light absorbing moiety may absorb energy applied from the outside and transfer it to the light emitting moiety, and may be designed to satisfy Equation 1 below and Equation 2 when the wavelength of the light emitting moiety is greater than or equal to 350 nm and less than 2500 nm.

< Formula 1 >

$$\left| E(1)_{HOMO} - E(1)_{LUMO} \right| \geq \left| E(2)_{HOMO} - E(2)_{LUMO} \right|$$

In Formula 1, $E(1)_{HOMO}$ represents the HOMO energy of the light absorbing moiety, $E(1)_{LUMO}$ represents the LUMO energy of the light absorbing moiety, $E(2)_{HOMO}$ represents the HOMO energy of the light emitting moiety, and $E(2)_{LUMO}$ represents the LUMO energy of the light emitting moiety.

< Formula 2 >

$$0.2 \times [I(E) \div I(A)] \leq N(2)/N(1)$$

In Formula 2, which I(A) represents the amount of light absorbed by the light emitting moiety, I(E) represents the amount of light emitted by the light emitting moiety, N(1) represents the amount of light absorbed by the light absorbing moiety, and N(2) represents the amount of light transferred to and emitted at the light emitting moiety.

For example, an appropriate light absorbing compound is connected to the light emitting compound that has been selected from a light emitting material, resulting in the multifunctional emitting compound, and thus the light absorbing moiety can be derived from the light absorbing compound. Thereby, the light absorbing compound can be regarded as a precursor of the light absorbing moiety.

For example, the light absorbing compound inducing the light absorbing moiety may be selected from a compound that has a desired light absorption spectrum and satisfies Formula 1 and Formula 2 when the wavelength of the light emitting moiety is greater than or equal to 350 nm and less than 2500 nm.

In one embodiment, the light absorbing moiety may have a molar extinction coefficient of 1000 or more at a maximum absorption wavelength of 300 nm or more.

In one embodiment, the light absorbing compound inducing the light absorbing moiety may be selected from a compound that has a molar extinction coefficient of 500 or more and satisfies Formula 1 and Formula 2 when the wavelength of the light emitting moiety is greater than or equal to 350 nm and less than 2500 nm.

Even though the light absorbing compound has low quantum efficiency, the reason why the light conversion efficiency of the multifunctional emitting compound can be excellent can be understood by referring to FIG. 3 illustrating the absorption-emission mechanism of the multifunctional emitting compound as previously mentioned.

Therefore, the quantum efficiency of the light absorbing compound may not be considered when selecting the light absorbing compound in order to design the multifunctional emitting compound.

The multifunctional emitting compound introduces a light absorbing moiety capable of only increasing absorption without affecting the emitting properties of the light emitting moiety. Since such energy is efficiently transferred to the light emitting moiety, excellent light conversion efficiency can be achieved.

In one embodiment, the energy down conversion system may implement a high efficiency light conversion system by being applied with the multifunctional emitting compound that absorbs a short wavelength light source and emits long wavelength light.

In one embodiment, the energy down conversion system may include a layer or a film including at least one kind of the multifunctional emitting compound.

The layer including at least one kind of multifunctional emitting compound may, optionally, include a polymer compound for forming a matrix, further.

The polymer compound for forming the matrix may include, for example, polyimide, poly acrylate, polyethylene terephthalate, and the like.

The layer including at least one kind of multifunctional emitting compound may, optionally, include an inorganic compound, further.

Examples of the inorganic compound include silicon oxide, aluminum oxide, titanium oxide, and molybdenium oxide.

In one embodiment, the multifunctional emitting compound may be applied to the energy down conversion system by a solution process. For example, the layer may be prepared by a spin coating process, an inkjet process, a slow die coating process, or a silk screen printing process, which are examples of solution processes.

The energy down conversion system can be applied not only to displays and lighting fields but also to solar cells and medical fields.

In an organic solar cell, materials capable of absorbing solar energy are positioned between an anode and a cathode. Once solar energy is absorbed, these materials become excited, and electrons move to the anode and holes move to the cathode, thereby generating electricity. Efficiency of electricity generation is proportional to light absorbance and proportional to the lifetime of the excited state of the material that has absorbed the light. The multifunctional emitting compound of the present disclosure absorbs high energy, transfers the energy to a light emitting moiety having high light emitting efficiency, and generates electrons and holes, thereby increasing electricity generation efficiency.

In the medical field, since the multifunctional emitting compound can obtain light with high efficiency even with small light source energy, it can be used for diagnosis by increasing sensitivity, converting it to have strong hydrophilic properties and by binding appropriate antigens or antibodies. In addition, by converting energy into near infrared rays using natural light or the visible light energy, it can be used in the medical field where near infrared rays are applied.

In one embodiment, the energy down conversion system includes a light source, and the multifunctional emitting compound causes color conversion with respect to the light source. That is, the range of the maximum absorption wavelength can be adjusted while keeping the color of light emitted constant. This means that, while the conventional diagnosis has been made by the color of light emitted, the energy down conversion system can make a diagnosis by changing the wavelength of a light source.

The light source may be an OLED light source or an inorganic LED light source.

In one embodiment, the multifunctional emitting compound may be applied as a fluorescent material for a diagnosis in biochemistry or medical fields. There are examples of a case of applying the multifunctional emitting compound in which a red light emitting moiety is connected to a 450 nm wavelength light absorbing compound and a case of applying the multifunctional emitting compound in which a red light emitting moiety is connected to a 500 nm wavelength light absorbing compound. Both materials exhibit red light emission, but one material strongly appears red when irradiated with a 450 nm light source, and the other material strongly appears red when irradiated with a 500 nm light source. Therefore, when the multifunctional emitting compound is introduced into a specific region during cell division, it may be possible to check what function this region will express in the future by changing the measuring light source. In addition, the multifunctional emitting compound has an advantage of minimizing cell destruction by reducing the intensity of a light source because absorption is increased by the light absorbing moiety.

One embodiment of the present disclosure provides an energy down conversion system wherein the energy down conversion system is an organic solar cell.

In one embodiment, the organic solar cell may include a first electrode, a second electrode, and a solar energy absorbing electricity generating layer interposed between the first electrode and the second electrode, and
the solar energy absorption electricity generating layer may include the multifunctional emitting compound.

The first electrode and the second electrode may be a cathode or an anode, respectively, or vice versa.

In the organic solar cell, the multifunctional emitting compound is used in a solar energy absorbing electricity generation layer between the first electrode and the second electrode of the organic solar cell, so that the light absorbing moiety increases the absorbance of high energy and short wavelength solar energy, and the light emitting moiety, to which it is transferred, converts it into a low energy state, thereby increasing electron generating efficiency.

In one embodiment of the present disclosure, the organic solar cell may include a substrate and a film attached to the top of the substrate,

the substrate may sequentially include a first electrode, a solar energy absorbing electricity generating layer, and a second electrode from bottom to top, and
the film may include the multifunctional emitting compound.

The first electrode and the second electrode may be a cathode or an anode, respectively, or vice versa.

For example, the multifunctional emitting compound may be coated as a film on the substrate of the organic solar cell. The multifunctional emitting compound formed as a film on the substrate absorbs short wavelength solar energy with high energy and converts it to long wavelength energy with low energy, and the converted energy is absorbed in the solar energy absorbing electricity generating layer between the anode and the cathode of the organic solar cell, thereby increasing electron generating efficiency.

Examples and comparative examples of the present disclosure are described below. The following examples are only examples of the present disclosure, but the present disclosure is not limited to the following examples.

## EXAMPLES

<u>SYNTHESIS EXAMPLE 1</u>

Compound 1-1 was prepared as a light absorbing compound and Compound 1-2 was prepared as a light emitting compound. Compound 1-3 below, in which the light absorbing moiety derived from Compound 1-1 and the light emitting moiety derived from Compound 1-2 were connected in a spiro structure, was synthesized as the multifunctional emitting compound.

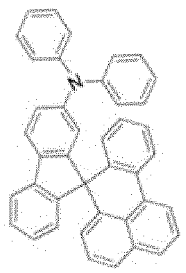

Compound 1-1

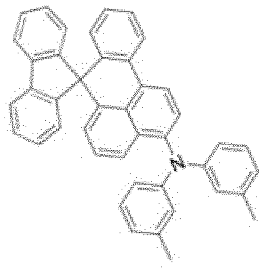

Compound 1-2

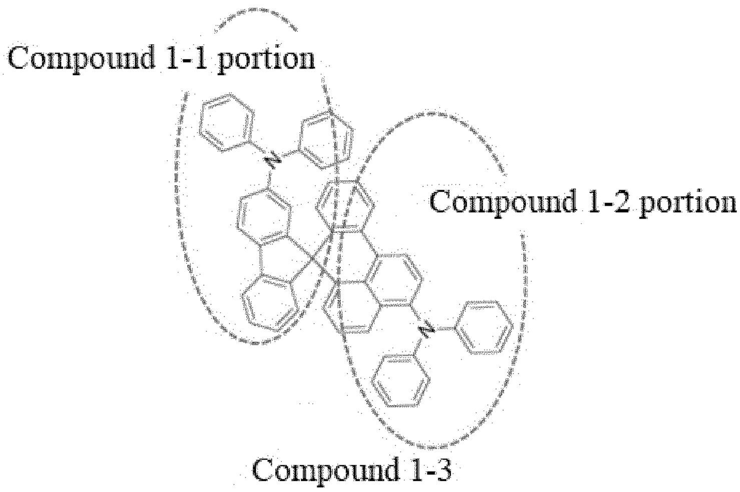


Compound 1-3

Fig. 4 schematically shows the absorption-emission mechanism of Compound 1-1, Compound 1-2 and Compound 1-3.

The HOMO energy of the light absorbing moiety, $E(1)_{HOMO}$; the LUMO energy of the light absorbing moiety, $E(1)_{LUMO}$; the HOMO energy of the light emitting moiety, $E(2)_{HOMO}$; and the LUMO energy of the light emitting moiety, $E(2)_{LUMO}$; in Compound 1-3 were measured and the values of $| E(1)_{HOMO} - E(1)_{LUMO} |$, $| E(2)_{HOMO} - E(2)_{LUMO} |$ in < Formula 1 > are shown in Table 1 below.

(Synthesis of Compound 1-1)

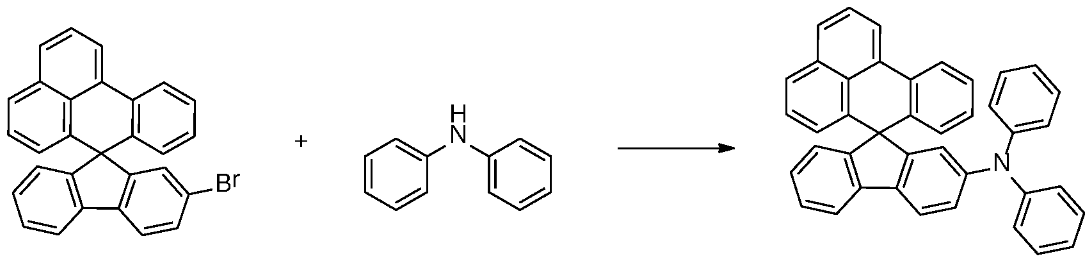

Compound 1-1-1 Compound 1-1-2 Compound 1-1

In a round bottom flask reactor, 4.45 g (10.0 mmol) of Compound 1-1-1, 2.03 g (0.012 mol) of Compound 1-1-2, 0.275 g (0.3 mmol) of tris(dibenzylideneacetone)dipaladium(0), 2.88 g (0.03 mol) of sodium tertiary butoxide, 0.606 g (0.3 mmol) of tri-tertiary-butyl phosphine, and 60 ml of toluene were added and stirred under reflux for 2 hours.

After cooling the reaction solution to room temperature, cooled water was added, and the organic layer was extracted using ethyl acetate. After drying the solvent of the extracted organic layer with $MgSO_4$, it was filtered. After concentrating the filtrate under reduced pressure, it was purified using a silica gel column chromatography (DCM/Hexane) method.

Thereafter, recrystallization and purification were performed using a DCM/Acetone mixed solvent to obtain 3.2 g of Compound 1-1 in a 60% yield.

MS (MALDI-TOF) m/z: 533[M]+

NMR: δH (400 MHz; $CDCl_3$; $Me_4Si$) 8.15 (d, J = 8.0, 2.0 Hz, 1H), 7.79 (d, 1H), 7.72-7.63 (m, 3H), 7.55 (t, 1H), 7.29-7.19 (m, 6H), 7.08 (t, 4H), 7.03 (dd, 1H), 6.98 (t, 1H), 6.93 (d, 4H), 6.91-6.81 (m, 4H), 6.72 (d, 1H),

(Synthesis of Compound 1-2)

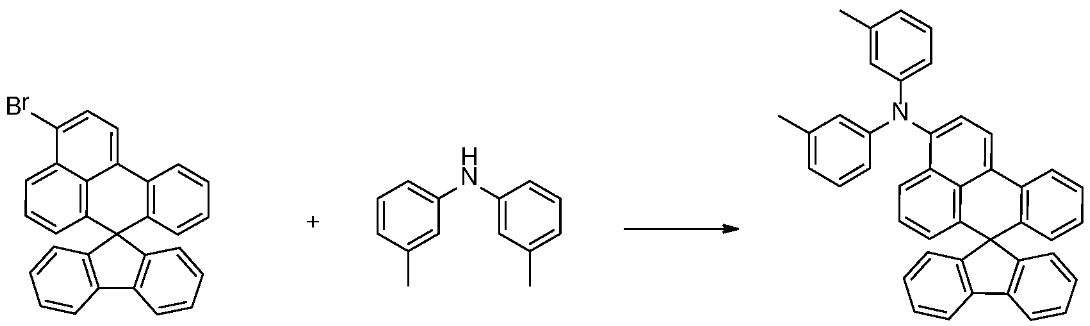

Compound 1-2-1 Compound 1-2-2 Compound 2

The same method of (Synthesis of Compound 1-1) above was proceeded except for using Compound 1-2-1 instead of Compound 1-1-1 and Compound 1-2-2 instead of Compound 1-1-2 in the same molar ratio as in (Synthesis of Compound 1-1).

Thereafter, 3.26 g of Compound 1-2 was obtained in a yield of 58%.

MS (MALDI-TOF) m/z: 561[M]+

(Synthesis of Compound 1-3)

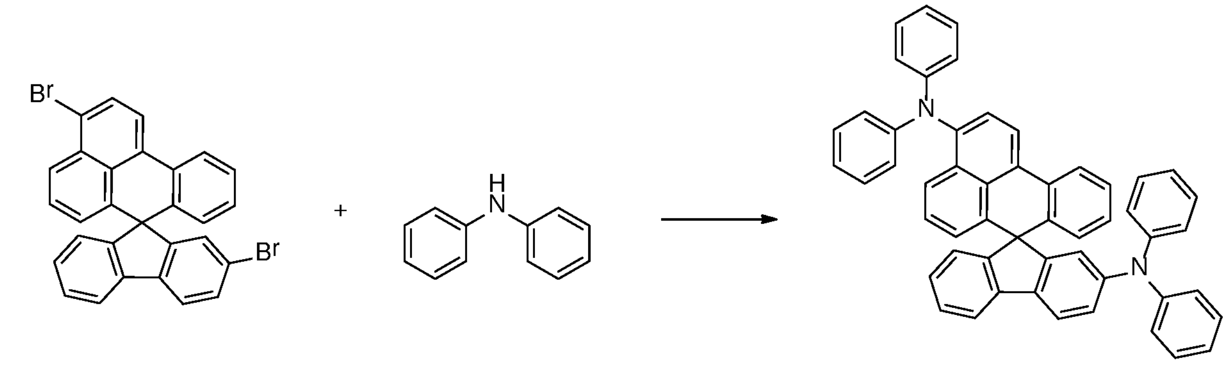

Compound 1-3-1 Compound 1-3-2 Compound 1-3

The same method of (Synthesis of Compound 1-1) above was proceeded except for using Compound 1-3-1 instead of Compound 1-1-1.

Thereafter, 4.34 g of Compound 1-3 was obtained in a yield of 62%.

MS (MALDI-TOF) m/z: 700[M]+

NMR: δH (400 MHz; $CDCl_3$; $Me_4Si$) 8.13 (d, J = 8.0, 2.0 Hz, 1H), 7.77 (d, 1H), 7.68 (t, 2H), 7.38 (d, 1H), 7.30-7.25 (m, 2H), 7.19 (t, 4H), 7.14-7.01 (m, 12H), 7.01-6.84 (m, 12H), 6.69 (d, 1H)

SYNTHESIS EXAMPLE 2

Compound 2-1 was prepared as a light absorbing compound and compound 2-2 was prepared as a light emitting compound. Compound 2-3 below, in which the light absorbing moiety derived from Compound 2-1 and the light emitting moiety derived from Compound 2-2 were connected in a spiro structure, was synthesized as the multifunctional emitting compound.

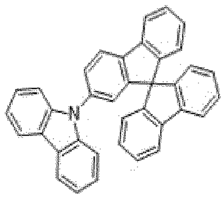

Compound 2-1

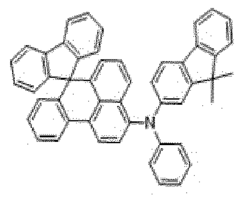

Compound 2-2

Compound 2-1 portion

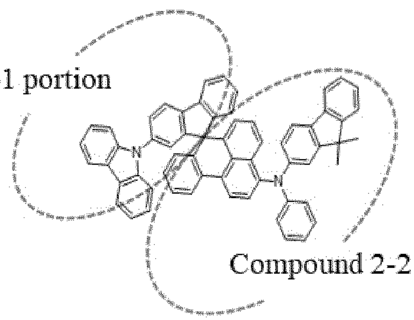

Compound 2-2 portion

Compound 2-3

Fig. 5 schematically shows the absorption-emission mechanism of Compound 2-1, Compound 2-2 and Compound 2-3.

The HOMO energy of the light absorbing moiety, $E(1)_{HOMO}$; the LUMO energy of the light absorbing moiety, $E(1)_{LUMO}$; the HOMO energy of the light emitting moiety, $E(2)_{HOMO}$; and the LUMO energy of the light emitting moiety,

$E(2)_{LUMO}$; in Compound 2-3 were measured and the values of | $E(1)_{HOMO}$ - $E(1)_{LUMO}$ |, | $E(2)_{HOMO}$ - $E(2)_{LUMO}$ | in < Formula 1 > are shown in Table 1 below.

(Synthesis of Compound 2-1)

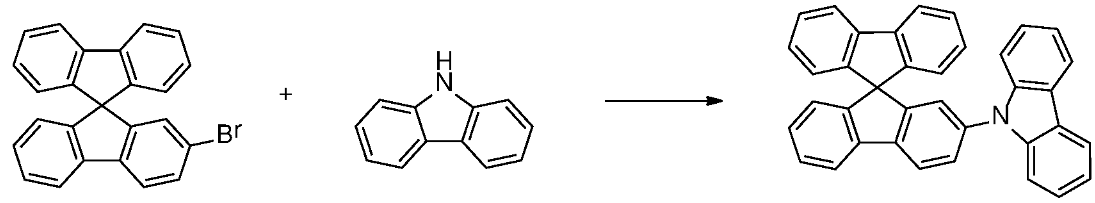

Compound 2-1-1 Compound 2-1-2 Compound 2-1

The same method of (Synthesis of Compound 1-1) above was proceeded except for using Compound 2-1-1 instead of Compound 1-1-1 and Compound 2-1-2 instead of Compound 1-1-2 in the same molar ratio as in (Synthesis of Compound 1-1).
Thereafter, 2.65 g of Compound 2-1 was obtained in a yield of 55%.
MS (MALDI-TOF) m/z: 481[M]+
NMR: δH (400 MHz; $CDCl_3$; $Me_4Si$) 8.04 (d, J = 8.0, 2.0 Hz, 3H), 7.91 (d, 1H), 7.78 (d, 2H), 7.56 (dd, 1H), 7.42 (t, 1H), 7.35 (t, 2H), 7.30-7.26 (m, 2H), 7.19 (t, 4H), 7.14 (t, 3H), 6.89 (sd, 1H), 6.85 (d, 2H), 6.79 (d, 1H)

(Synthesis of Compound 2-2)

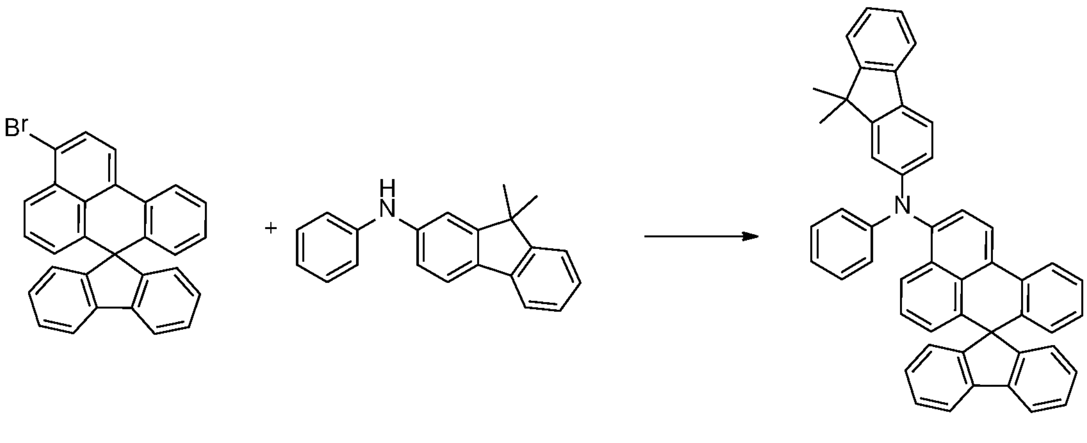

Compound 2-2-1 Compound 2-2-2 Compound 2-2

The same method of (Synthesis of Compound 1-1) above was proceeded except for using Compound 2-2-1 instead of Compound 1-1-1 and Compound 2-2-2 instead of Compound 1-1-2 in the same molar ratio as in (Synthesis of Compound 1-1).
Thereafter, 3.70 g of Compound 2-2 was obtained in a yield of 57%.
MS (MALDI-TOF) m/z: 649[M]+

(Synthesis of Compound 2-3)

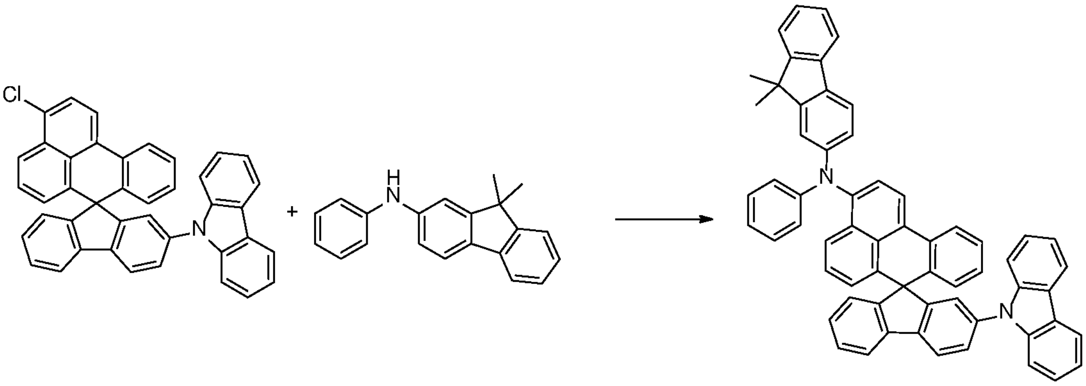

Compound 2-3-1 Compound 2-3-2 Compound 2-3

The same method of (Synthesis of Compound 1-1) above was proceeded except for using Compound 2-3-1 instead of Compound 1-1-1 and Compound 2-3-2 instead of Compound 1-1-2 in the same molar ratio as in (Synthesis of Compound 1-1).

Thereafter, 4.89 g of Compound 2-3 was obtained in a yield of 60%.

MS (MALDI-TOF) m/z: 814[M]+

NMR: δH (400 MHz; $CDCl_3$; $Me_4Si$) 8.18 (d, J = 8.0, 2.0 Hz, 1H), 8.05 (d, 2H), 8.02 (d, 1H), 7.89 (d, 1H), 7.84 (d, 1H), 7.57 (d, 2H), 7.48 (d, 1H), 7.42 (t, 3H), 7.33 (d, 2H), 7.29-7.27 (m, 2H), 7.23-7.13 (m, 13H), 7.10 (t, 4H), 6.96-6.90 (m, 2H), 6.73 (d, 1H), 1.33 (s, 3H) 1.32 (s, 3H)

SYNTHESIS EXAMPLE 3

Compound 3-1 was prepared as a light absorbing compound and compound 3-2 was prepared as a light emitting compound. Compound 3-3 below, in which the light absorbing moiety derived from Compound 3-1 and the light emitting moiety derived from Compound 3-2 were connected in a spiro structure, was synthesized as the multifunctional emitting compound.

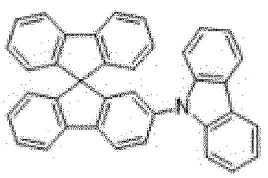

Compound 3-1

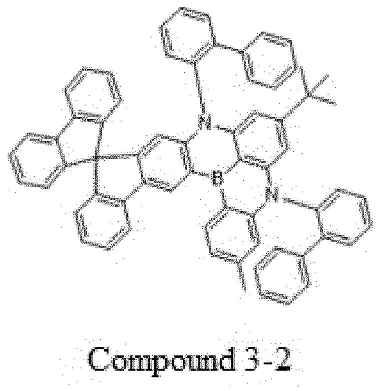

Compound 3-2

Compound 3-3

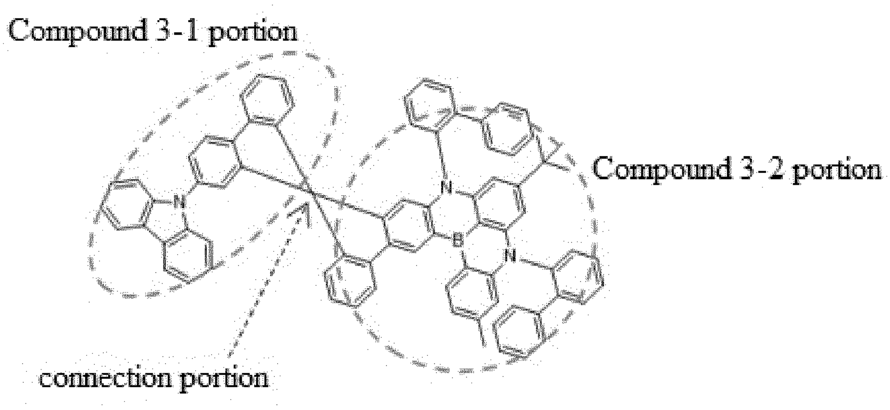


Fig. 6 schematically shows the absorption-emission mechanism of Compound 3-1, Compound 3-2 and Compound 3-3.

The HOMO energy of the light absorbing moiety, $E(1)_{HOMO}$; the LUMO energy of the light absorbing moiety, $E(1)_{LUMO}$; the HOMO energy of the light emitting moiety, $E(2)_{HOMO}$; and the LUMO energy of the light emitting moiety, $E(2)_{LUMO}$; in Compound 3-3 were measured and the values of $| E(1)_{HOMO} - E(1)_{LUMO} |$, $| E(2)_{HOMO} - E(2)_{LUMO} |$ in < Formula 1 > are shown in Table 1 below.

(Synthesis of Compound 3-1)

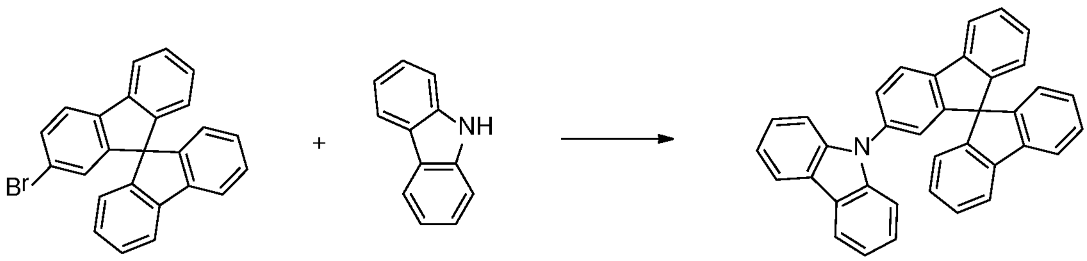

Compound 3-1-1 Compound 3-1-2 Compound 3-1

The same method of (Synthesis of Compound 1-1) above was proceeded except for using Compound 2-1-1 instead of Compound 1-1-1 and Compound 2-1-2 instead of Compound 1-1-2 in the same molar ratio as in (Synthesis of Compound 1-1).

Thereafter, 2.65 g of Compound 2-1 was obtained in a yield of 55%.

MS (MALDI-TOF) m/z: 481[M]+

(Synthesis of Compound 3-2)

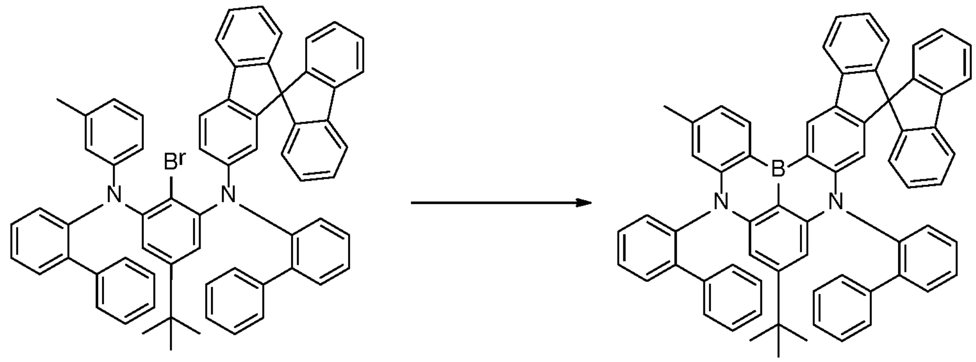

Compound 3-2-1 Compound 3-2

After dissolving 9.52 g (10.0 mmol) of the starting material 3-2-1 in tertiary butylbenzene (32 ml), it was cooled to 0 °C. Under nitrogen atmosphere, 8.0 mL (20.0 mmol) of 2.5M n-butyllithium solution (in hexane) was added and stirred at room temperature for 3 hours.

Then, the reactant was cooled to 0°C, and after adding 1.90 mL (20.0 mmol) of boron tribromide, followed by stirring at room temperature for 0.5 hour. The reactant was cooled to 0°C again, and 3.51 mL (20.0mmol) of N,N-diisopropylethylamine was added thereto, followed by stirring at 60-70°C for 2 hours.

The reaction solution was cooled to room temperature, and the organic layer was extracted with ethyl acetate. After drying the solvent of the extracted organic layer with MgSO4, it was filtered. After concentrating the filtrate under reduced pressure, it was purified using a silica gel column chromatography (DCM/Hexane) method.

Thereafter, recrystallization and purification were performed using a DCM/acetone mixed solvent to obtain 1.05 g of the compound 3-2 in a yield of 12%.

MS (MALDI-TOF) m/z: 880[M]+

NMR: δH (400 MHz; $CDCl_3$; $Me_4Si$) 9.13(1 H, s), 8.86-8.83 (1 H, m), 7.92-7.90 (1 H, m), 7.78 (1 H, d, J 8.0), 7.73-7.64 (4 H, m), 7.44-7.27 (8 H, m), 7.17-6.86 (11 H, m), 6.80-6.57(5 H, m), 6.49(1 H, d, J 4.0).6.37(1 H, d, J 8.0), 6.12(2 H, t), 5.89(1 H, d, J 8.0), 2.36(3 H, s), 0.96(9 H, s)

(Synthesis of Compound 3-3)

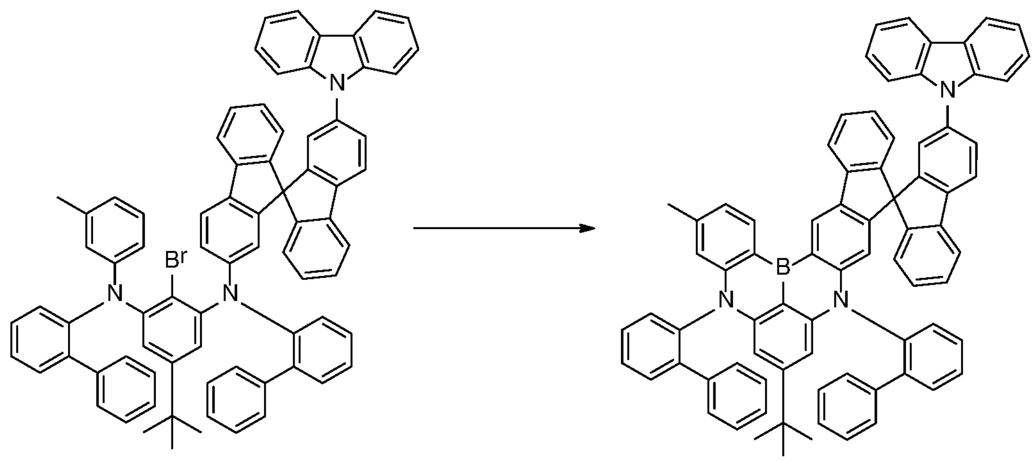

Compound 3-3-1 Compound 3-3

The same method of (Synthesis of Compound 3-2) above was proceeded except for using Compound 3-3-1 instead of Compound 3-2-1 in the same molar ratio as in (Synthesis of Compound 3-2).

Thereafter, 1.0 g of Compound 3-3 was obtained in a yield of 9%.

MS (MALDI-TOF) m/z: 1046[M]+

NMR: δH (400 MHz; $CDCl_3$; $Me_4Si$) 9.13(1 H, s), 8.86-8.83 (1 H, m), 7.92-7.90 (1 H, m), 7.78 (1 H, d, J 8.0), 7.73-7.64

(6 H, m), 7.44-7.27 (11 H, m), 7.17-6.86 (13 H, m), 6.80-6.57(5 H, m), 6.49(1 H, d, J 4.0).6.37(1 H, d, J 8.0), 6.12(2 H, t), 5.89(1 H, d, J 8.0), 2.36(3 H, s), 0.96(9 H, s)

SYNTHESIS EXAMPLE 4

Compound 3-1 was prepared as a light absorbing compound and compound 3-2 was prepared as a light emitting compound. Compound 3-4 below, in which two light absorbing moieties derived from Compound 3-1 were connected to the light emitting moiety derived from Compound 3-2, respectively in a spiro structure, was synthesized as the multifunctional emitting compound.

Fig. 7 schematically shows the absorption-emission mechanism of Compound 3-4 synthesized in Example.

(Synthesis of Compound 3-4)

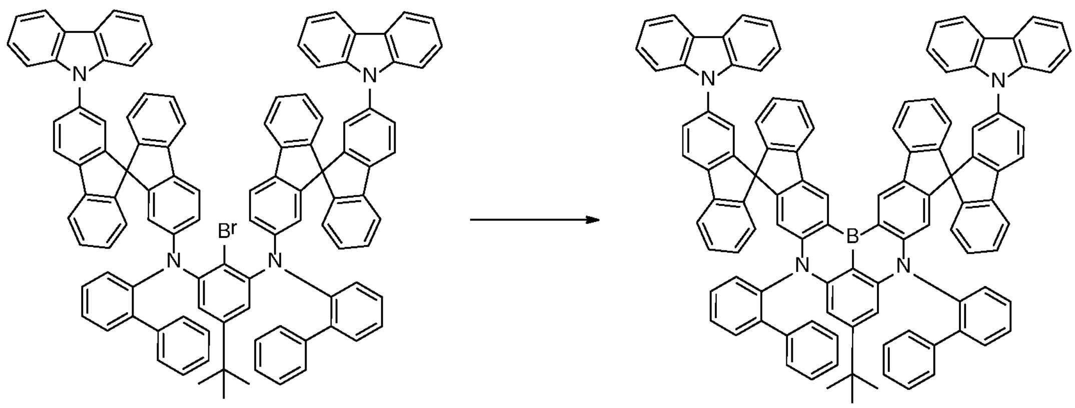

Compound 3-4-1 Compound 3-4

The same method of (Synthesis of Compound 3-2) above was proceeded except for using Compound 3-4-1 instead of Compound 3-2-1 in the same molar ratio as in (Synthesis of Compound 3-2).

MS (MALDI-TOF) m/z: 1435[M]+

NMR: $\delta$H (400 MHz; $CDCl_3$; $Me_4Si$) 9.22-9.15 (m, 2H), 8.07-8.01 (m, J=8.0, 2.0 Hz, 4H), 8.00-7.90 (m, 4H), 7.89-7.78 (m, 2H), 7.60-7.28 (m, 21H), 7.22-7.07 (m, 13H), 7.01-6.91 (m, 2H), 6.87-6.68 (m, 7H), 6.59-6.52 (m, 3H), 6.47-6.28 (m, 1H), 6.26-6.02 (m, 3H), 1.24 (s, 9H)

Evaluation 1: Measurement of HOMO energy and LUMO energy

The HOMO energy and the LUMO energy of Compound 1-3, Compound 2-3, Compound 3-3 and Compound 3-4, as synthesized above, were measured and the values of $| E(1)_{HOMO} - E(1)_{LUMO} |$ , $| E(2)_{HOMO} - E(2)_{LUMO} |$ in < Formula 1 > are shown in Table 1 below.

The HOMO energy was measured by CV, Cyclic Voltametry, and the LUMO energy was measured by absorption spectrum.

TABLE 1

| Index | $\| E(1)_{HOMO} - E(1)_{LUMO} \|$ | $\| E(2)_{HOMO} - E(2)_{LUMO} \|$ |
|---|---|---|
| Compound 1-3 | 3.24 | 2.83 |
| Compound 2-3 | 3.24 | 2.86 |
| Compound 3-3 | 3.52 | 2.74 |
| Compound 3-4 | 3.52 | 2.62 |

Evaluation 2: Measurement of the molar extinction coefficient of the light absorbing moiety

The molar extinction coefficients (L $mol^{-1}cm^{-1}$) of the light absorbing moieties of Compound 1-3, Compound 2-3, Compound 3-3 and Compound 3-4, as synthesized above, were measured using SHIMADZU RF5301PC, SHIMADZU UV 2550.

**TABLE 2**

| Index | Maximum absorption wavelength above 300 nm | absorbance | concentration | Molar extinction coefficient of light absorbing moiety (L $mol^{-1}cm^{-1}$) |
|---|---|---|---|---|
| Light absorbing moiety derived from compound 1-1 in compound 1-3 | 346nm | 0.079 | 2.5μM | 31600 |
| Light absorbing moiety derived from compound 2-1 in compound 2-3 | 329nm | 0.069 | 2.5μM | 27000 |
| Light absorbing moiety derived from compound 3-1 in compound 3-3 | 329nm | 0.069 | 2.5μM | 27000 |
| Light absorbing moiety derived from compound 3-1 in compound 3-4 | 329nm | 0.069 | 2.5μM | 27000 |

Comparative Example 1

For all measurement samples, each material was dissolved in a toluene solution to have 2 micromolar concentration, and was measured using SHIMADZU RF5301PC, SHIMADZU UV 2550.

Fig. 8 shows the absorption and the emission spectra measured for a mixture of Compound 1-1 and Compound 1-2.

Compound 1-1 and Compound 1-2 were mixed at a ratio of 1:1 to have 2 micromolar concentration, respectively, and excited using 350 nm energy. As shown in FIG. 8, it was confirmed that Compound 1-1 and Compound 1-2 emit light independently, and energy transfer does not occur well.

Example 1

FIG. 9 shows the absorption and the emission spectra measured for Compounds 1-1, 1-2 and 1-3. In FIG. 1, energy transfer between moieties in Compound 1-3 was confirmed by comparing the energy transfer phenomena of Compound 1-1, Compound 1-2 and Compound 1-3.

Comparing the absorption spectra of Compound 1-2 and Compound 1-3, it can be confirmed that the absorbance in the 300-350 nm region of Compound 1-3 is increased, which is due to the absorption of the light absorbing moiety of Compound 1-3. Absorbance at 350 nm in Compound 1-3 increased by about 4 times compared to Compound 1-2. A phenomenon in which energy is transferred from the light absorbing moiety to the light emitting moiety in Compound 3-3, which is a multifunctional light emitting compound, can be confirmed through the emission spectra of the two materials. When Compound 1-2 and Compound 1-3 were excited at 350 nm, the emission intensity of the light emitting

moiety of Compound 1-3 increased by about 3.7 times compared to that of Compound 1-2, and the emission spectrum of the light absorbing moiety disappeared. Through this, it can be clearly confirmed that the energy transfer phenomenon described in FIG. 3 is implemented.

Example 2

FIG. 10 shows the absorption and the emission spectra measured for Compounds 2-1, 2-2 and 2-3. In FIG. 10, energy transfer between the moieties in Compound 2-3 was confirmed by comparing the energy transfer phenomena of Compound 2-1, Compound 2-2 and Compound 2-3. FIG. 10 shows the absorption and the emission spectra measured for Compounds 2-1, 2-2 and 2-3.

Comparing the absorption spectra of Compound 2-2 and Compound 2-3, it can be confirmed that the absorbance in the 300 to 350 nm region is increased in Compound 2-3, which is due to the absorption of the light absorbing moiety of Compound 2-3. Absorbance at 330 nm in Compound 2-3 increased by about 1.8 times compared to Compound 2. A phenomenon in which energy is transferred from the light absorbing moiety to the light emitting moiety in Compound 3-3, which is a multifunctional emitting compound, can be confirmed through the emission spectra of the two materials. When Compound 2-2 and Compound 2-3 were excited at 330 nm, the emission intensity of the light emitting moiety of Compound 3-3 increased by about 1.7 times compared to that of Compound 2, and the emission spectrum of the light absorbing moiety disappeared. Through this, it can be clearly confirmed that the energy transfer phenomenon described in FIG. 3 is implemented.

Through this Example 2, it was confirmed that energy transfer occurs efficiently when the distance between the energy donor (light absorbing compound) and the energy acceptor (light emitting compound) is very close (i.e., through chemical bonding).

Example 3

FIG. 11 shows the absorption and the emission spectra measured for Compounds 3-1, 3-2 and 3-3. In FIG. 11, energy transfer between the moieties in Compound 3-3 was confirmed by comparing the energy transfer phenomena of Compound 3-1, Compound 3-2 and Compound 3-3. FIG. 11 shows the absorption and the emission spectra measured for Compounds 3-1, 3-2 and 3-3.

Comparing the absorption spectra of Compound 3-2 and Compound 3-3, it can be confirmed that the absorbance in the 300-350 nm region of Compound 3-3 is increased, which is due to the absorption of the light absorbing moiety of Compound 3-3. Absorbance at 330 nm in Compound 3-3 increased by about 2 times compared to Compound 2. A phenomenon in which energy is transferred from the light absorbing moiety to the light emitting moiety in Compound 3-3, which is a multifunctional emitting compound, can be confirmed through emission spectra of the two materials. When Compound 3-2 and Compound 3-3 were excited at 330 nm, the emitting intensity of the light emitting moiety of Compound 3-3 increased by about 1.8 times compared to that of Compound 2, and the emission spectrum of the light absorbing moiety disappeared. Through this, it can be clearly confirmed that the energy transfer phenomenon described in FIG. 3 is implemented.

Through Example 3, it was confirmed that energy transfer occurs efficiently when the distance between the energy donor (light absorbing compound) and the energy acceptor (light emitting compound) is very close (i.e., through chemical bonding.

Example 4

FIG. 12 shows the absorption and the emission spectra measured for Compounds 3-3 and 3-4. Through Compound 3-3 and Compound 3-4, the energy transfer phenomena were compared when one light absorbing moiety was connected and when two light absorbing moieties were connected.

Comparing the absorption spectra of Compound 3-2 and Compound 3-3, it can be confirmed that the absorbance in the 300 to 350 nm region is increased in Compound 3-3, which is due to the absorption of the light absorbing moiety derived from Compound 3-1. The energy transfer phenomenon when two light absorbing moieties exist can be confirmed by comparing the absorption and emission spectra of Compound 3-3 having one light absorbing moiety and Compound 3-4 having two light absorbing moieties. When Compound 3-3 and Compound 3-4 were excited at 330 nm, the emitting intensity of the light emitting moiety of compound 3-4 was improved by about 30% compared to that of compound 3-3, and the emission spectrum of the light absorbing moiety disappeared. Through this, it can be clearly confirmed that the energy transfer phenomenon described in FIG. 3 is implemented also when there are two light absorbing moieties.

Through this Example 4, it was confirmed that energy transfer occurs efficiently when the distance between the energy donor (light absorbing compound) and the energy acceptor (light emitting compound) is very close (i.e., through chemical bonding).

< Preparation of Film >

It was confirmed that light conversion efficiency was improved also when the multifunctional emitting compound was applied to an energy down conversion system in the form of a film.

Comparative Example 2

After dissolving 1 g of PMMA and 0.1 g of Compound 1-2 in 3 ml of chlorobenzene, a 100 nm film was prepared by spin coating on Quartz Glass. An 8W 365nm UV lamp was used to induce the energy conversion phenomenon to blue, and the luminance was measured using a PR650 Spectraphotometer, and a value of CIE x 0.151, y 0.090 was obtained at about 29 nits.

Example 5

Except for using 0.1 g of Compound 1-3, a film was produced and measured in the same manner as in Comparative Example 2, and a value of CIE x 0.148 and y 0.094 was obtained at about 59 nits. Since the molecular weight ratio of Compound 1-2 and Compound 1-3 is about 1.3, when converted based on the same number of moles, the amount of light of Compound 1-3 is about 76.7 nits, which means that the energy down conversion efficiency is improved by about 2.6 times.

Fig. 13 is the emission spectrum measured for the films prepared in Comparative Example 2 and Example 5, respectively.

While the present disclosure has been described with reference to the drawings as exemplified about the present disclosure, the embodiments in Examples and the drawings set forth herein are not intended to limit the present disclosure, and it is obvious that various modifications can be made by those skilled in the art within the scope of the technical spirit of the present disclosure. In addition, even if not explicitly described about functioning effects according to the configurations of the present disclosure in the foregoing detailed description of embodiments, it is apparent that predictable effects of the corresponding configurations should also be acknowledged.

## Claims

**1.** An energy down conversion system that receives energy from outside and converts it into low energy,

wherein the system comprises a multifunctional emitting compound;
the multifunctional emitting compound includes a light emitting moiety and a light absorbing moiety;
the light absorbing moiety absorbs energy and transfers it to the light emitting moiety;
Formula 1 below is satisfied, in which a HOMO energy of the light absorbing moiety is $E(1)_{HOMO}$, a LUMO energy of the light absorbing moiety is $E(1)_{LUMO}$, a HOMO energy of the light emitting moiety is $E(2)_{HOMO}$, and a LUMO energy of the light emitting moiety is $E(2)_{LUMO}$;

< Formula 1 >

$$\left| E(1)_{HOMO} - E(1)_{LUMO} \right| \geq \left| E(2)_{HOMO} - E(2)_{LUMO} \right|$$

Formula 2 below is satisfied when a wavelength of the light emitting moiety is greater than or equal to 350 nm and less than 2500 nm, in which an amount of light absorbed by the light emitting moiety is I(A), an amount of light emitted by the light emitting moiety is I(E), an amount of light absorbed by the light absorbing moiety is N(1), and an amount of light transferred to and emitted at the light emitting moiety is N(2); and

< Formula 2 >

$$0.2 \times [I(E) \div I(A)] \leq N(2)/N(1)$$

in the multifunctional emitting compound, the light emitting moiety and the light absorbing moiety are chemically connected so that a shortest distance between the moieties is within 10 Å.

2. The energy down conversion system according to claim 1, wherein the light absorbing moiety has a molar extinction coefficient of 1000 or more at a maximum absorption wavelength of 300 nm or more.

3. The energy down conversion system according to claim 1, wherein the emitting moiety is derived from an emitting material.

4. The energy down conversion system according to claim 1, wherein the emitting moiety has a conjugated structure with a quantum efficiency of 10% or more in the visible light wavelength range of 400 nm to 650 nm.

5. The energy down conversion system according to claim 1, wherein the emitting moiety has a conjugated structure with a quantum efficiency of 0.5% or more in the near infrared wavelength range of 650 nm to 2500 nm.

6. The energy down conversion system according to claim 1, the multifunctional emitting compound includes at least one deuterium substituent.

7. The energy down conversion system according to claim 1, wherein for the light absorbing moiety and the light emitting moiety, the light absorbing moiety and the light emitting moiety are connected via a linking group, in a direct bond, or in a spiro connection without a linking group.

8. The energy down conversion system according to claim 7, wherein when the light absorbing moiety and the light emitting moiety are connected in the direct bond, a carbon atom in the light absorbing moiety and a carbon atom in the light emitting moiety are directly connected,

   when the light absorbing moiety and the light emitting moiety are connected via a linking group, the linking group is a substituted phenylene group; a substituted or unsubstituted arylene having 6 to 20 carbon atoms or heteroarylene having 5 to 20 carbon atoms, and the substituent when the phenylene group, the arylene, and the heteroarylene are substituted is at least one selected from the group consisting of deuterium, an alkyl group having 1 to 20 carbon atoms, an alkoxy group having 1 to 20 carbon atoms, a halogen, a cyano group, a carboxy group, a carbonyl group, an amine group, an alkyl amine group having 1 to 20 carbon atoms, a nitro group, an alkylsilyl group having 1 to 20 carbon atoms, an alkoxysilyl group having 1 to 20 carbon atoms, cycloalkylsilyl group having 3 to 30 carbon atoms, arylsilyl group having 6 to 30 carbon atoms, aryl group having 6 to 30 carbon atoms, arylamine group having 6 to 30 carbon atoms, heteroaryl group having 5 to 30 carbon atoms, arylphosphine oxide group having 6 to 30 carbon atoms, an aryl phosphinyl group having 6 to 30 carbon atoms, an alkylphosphine oxide group having 6 to 30 carbon atoms, and an alkylsulfonyl group having 6 to 30 carbon atoms and combinations thereof; or the linking group is a carbon atom, an oxygen atom, a nitrogen atom, a silicon atom, a Ge atom, an S atom, or a P atom, and when the linking group is an atom, a substituent selected from hydrogen, an alkyl having 1 to 20 carbon atoms, an aryl having 6 to 20 carbon atoms, a heteroaryl having 5 to 20 carbon atoms and combinations thereof can be included;

   when the light absorbing moiety and the light emitting moiety form a spiro connection that shares an atom capable of forming a spiro connection, the spiro connection is connected via carbon, silicon, or Ge as a spiro atom.

9. The energy down conversion system according to claim 1, wherein the linking group is a conjugated structure such that the shortest distance between the light absorbing moiety and the light emitting moiety is within 10 Å, and a bandgap energy of the conjugated structure is greater than a bandgap energy of the light absorbing moiety.

10. The energy down conversion system according to claim 1, wherein a HOMO energy level, a LUMO energy level or a band gap energy of the moieties is not changed by more than 0.2 eV by chemically bonding the light absorbing moiety and the light emitting moiety.

11. The energy down conversion system according to claim 1, wherein the light emitting moiety has a conjugated structure including boron.

12. The energy down conversion system according to claim 1, wherein the light emitting moiety contains a metal.

13. The energy down conversion system according to claim 1, wherein the multifunctional emitting compound includes at least one light absorbing moiety, and the at least one light absorbing moiety is connected to the light emitting moiety in a spiro connection, respectively.

**14.** The energy down conversion system according to claim 1, wherein the multifunctional emitting compound includes at least one light emitting moiety, and the at least one light emitting moiety is connected to the light absorbing moiety in a spiro connection, respectively.

**15.** The energy down conversion system according to claim 1, wherein the multifunctional emitting compound includes at least one light emitting moiety and at least one light absorbing moiety, and the combination of the light emitting moiety and the light absorbing moiety connects in a spiro connection.

**16.** The energy down conversion system according to claim 1, comprising a layer that includes at least one kind of multifunctional emitting compound.

**17.** The energy down conversion system according to claim 1, wherein the multifunctional emitting compound is applied to the energy down conversion system by a solution process.

**18.** The energy down conversion system according to claim 1, wherein the energy down conversion system includes a light source, and the multifunctional emitting compound causes color conversion with respect to the light source.

**19.** The energy down conversion system according to claim 18, wherein the light source is an OLED light source or an inorganic LED light source.

**20.** The energy down conversion system according to claim 1, wherein the multifunctional emitting compound is applied as a fluorescent material for diagnosis in biochemistry or medical field.

**21.** The energy down conversion system according to claim 1, wherein the energy down conversion system is an organic solar cell,

the organic solar cell includes a first electrode, a second electrode, and a solar energy absorbing electricity generating layer interposed between the first electrode and the second electrode, and
the solar energy absorbing electricity generating layer includes the multifunctional emitting compound.

**22.** The energy down conversion system according to claim 1, wherein the energy down conversion system is an organic solar cell,

the organic solar cell includes a substrate and a film attached to the top of the substrate,
the substrate sequentially includes a first electrode, a solar energy absorbing electricity generating layer, and a second electrode from bottom to top, and
the film includes the multifunctional emitting compound.

[Fig. 1]

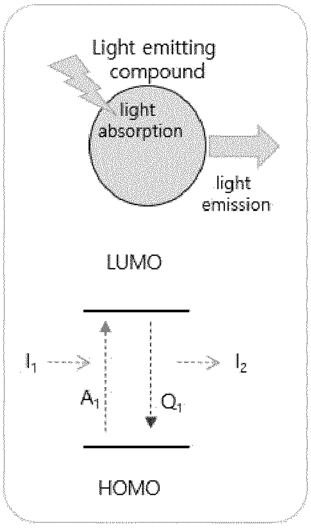
Light emitting compound
light absorption
light emission
LUMO
$I_1$
$I_2$
$A_1$
$Q_1$
HOMO

[Fig. 2]

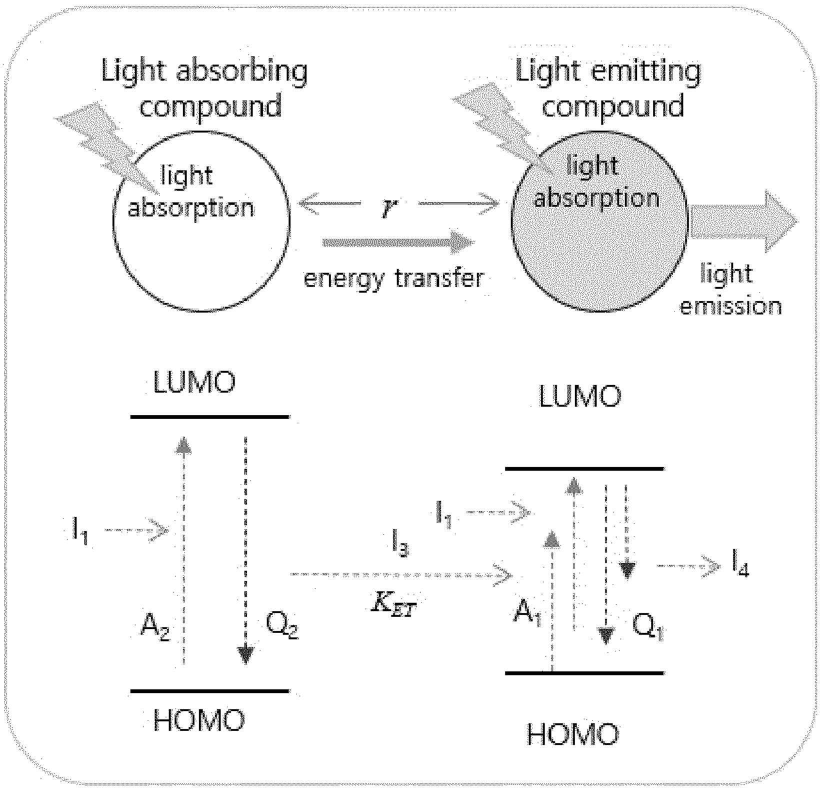
Light absorbing compound
light absorption
Light emitting compound
light absorption
r
energy transfer
light emission
LUMO
LUMO
$I_1$
$I_1$
$I_3$
$I_4$
$K_{ET}$
$A_2$
$Q_2$
$A_1$
$Q_1$
HOMO
HOMO

[Fig. 3]

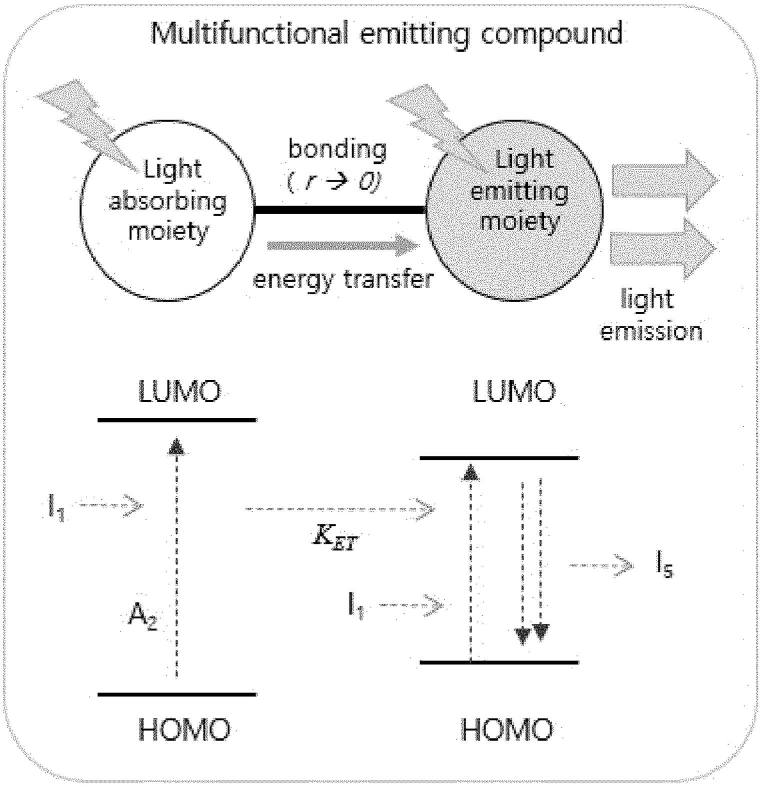
Multifunctional emitting compound
Light absorbing moiety
bonding
( r → 0)
energy transfer
Light emitting moiety
light emission
LUMO
LUMO
I1
A2
KET
I1
I5
HOMO
HOMO

[Fig. 4]

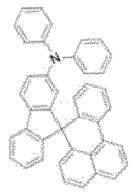

Compound 1-1

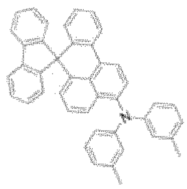

Compound 1-2

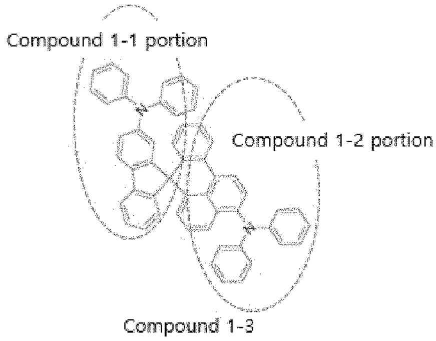


Compound 1-3

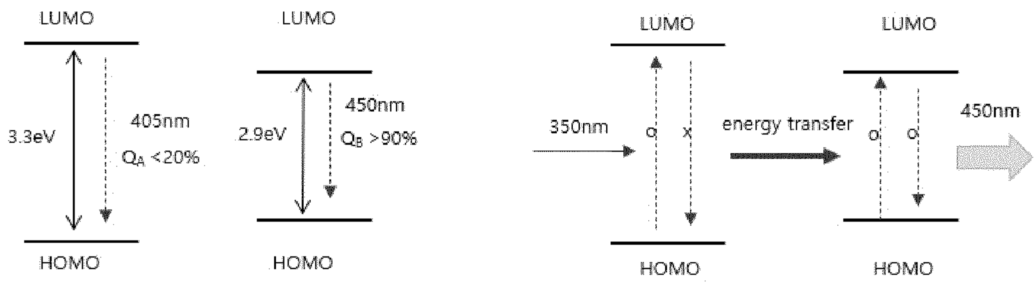

[Fig. 5]

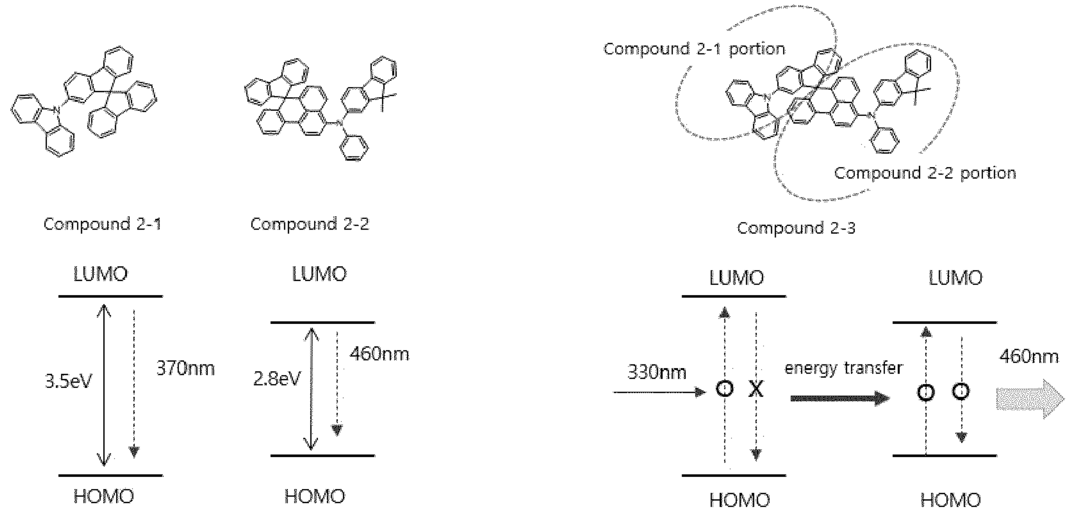


Compound 2-1

Compound 2-2

Compound 2-3

[Fig. 6]

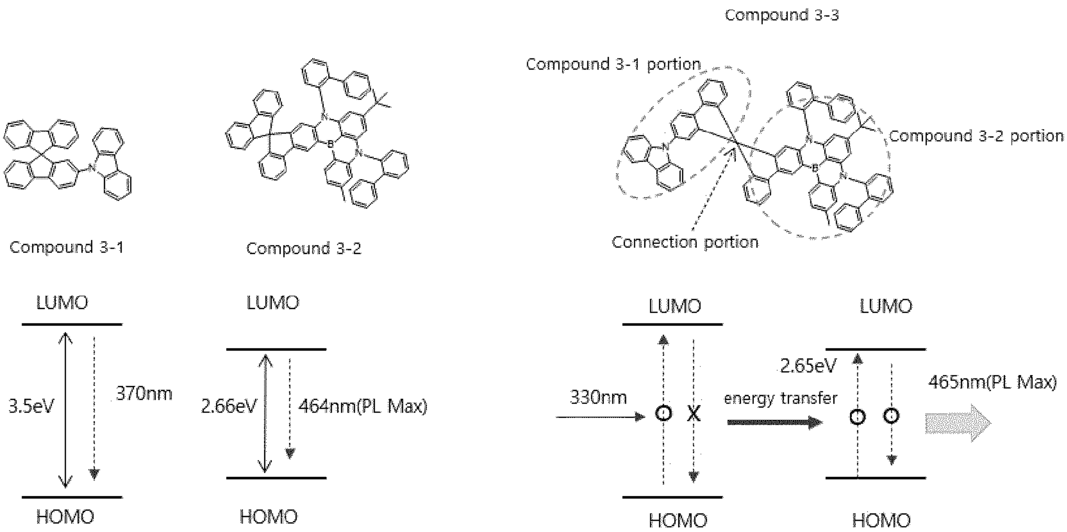


Compound 3-1

Compound 3-2

Compound 3-3

[Fig. 7]

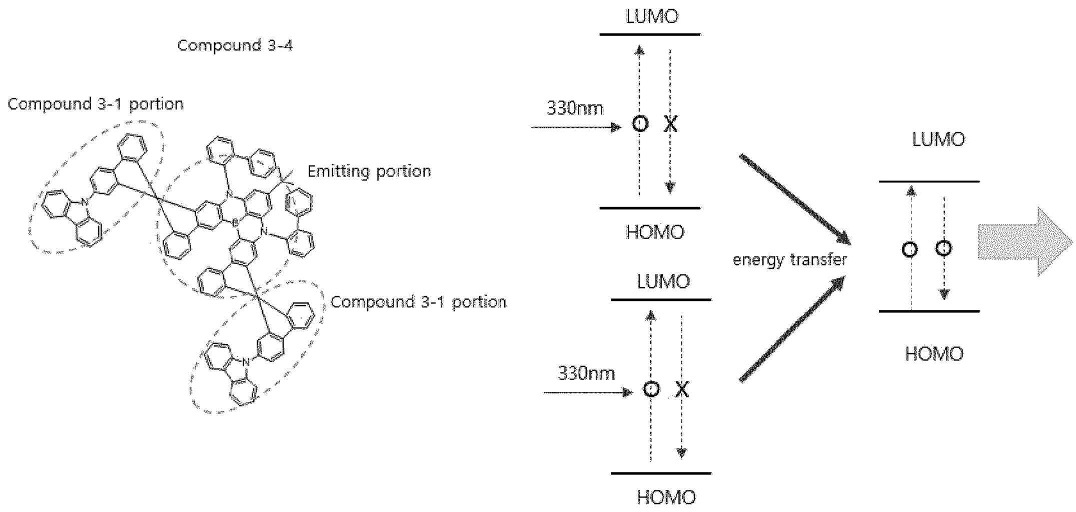
Compound 3-4
Compound 3-1 portion
Emitting portion
Compound 3-1 portion
LUMO
330nm
HOMO
energy transfer
LUMO
330nm
HOMO
LUMO
HOMO

[Fig. 8]

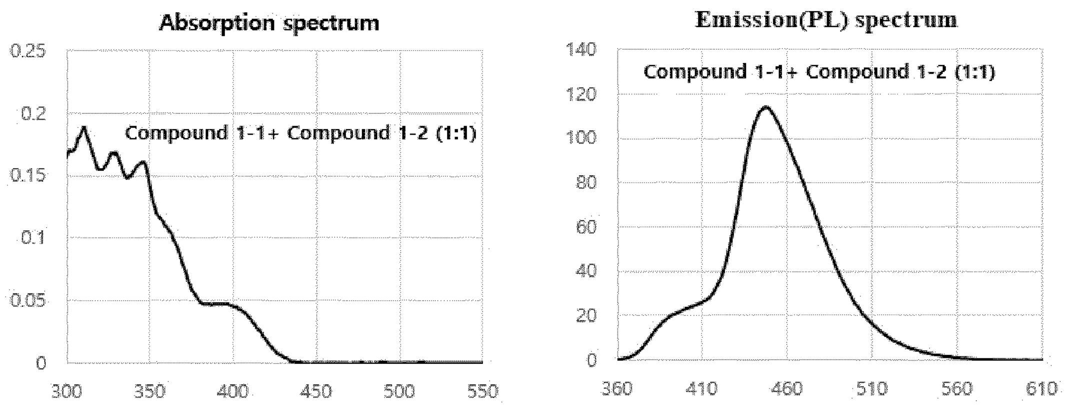
Absorption spectrum
Compound 1-1+ Compound 1-2 (1:1)
0.25
0.2
0.15
0.1
0.05
0
300
350
400
450
500
550
Emission(PL) spectrum
Compound 1-1+ Compound 1-2 (1:1)
140
120
100
80
60
40
20
0
360
410
460
510
560
610

[Fig. 9]

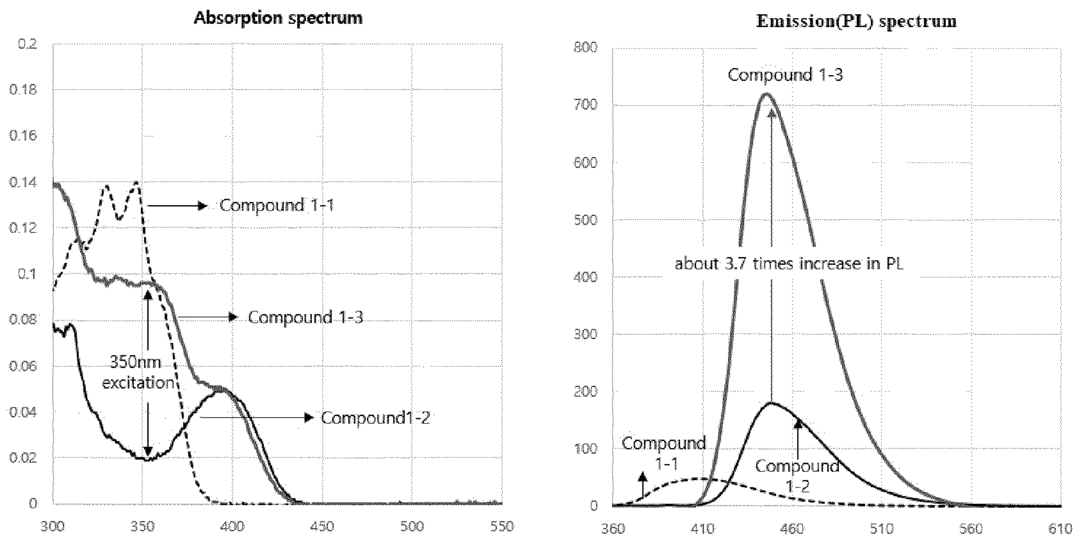
Absorption spectrum
Compound 1-1
Compound 1-3
350nm excitation
Compound1-2
Emission(PL) spectrum
Compound 1-3
about 3.7 times increase in PL
Compound 1-1
Compound 1-2

[Fig. 10]

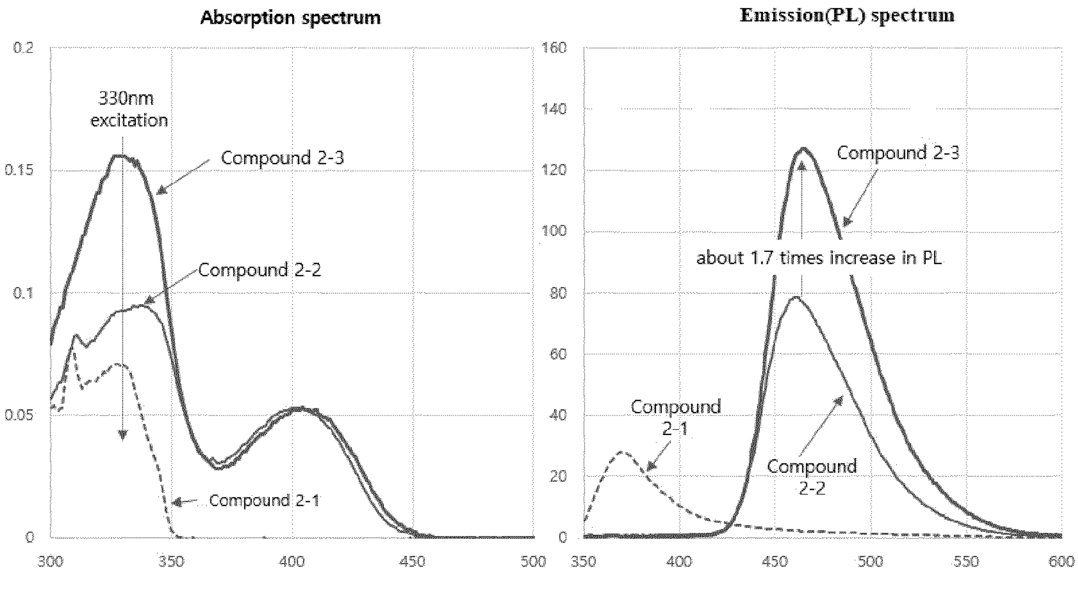
Absorption spectrum
330nm excitation
Compound 2-3
Compound 2-2
Compound 2-1
Emission(PL) spectrum
Compound 2-3
about 1.7 times increase in PL
Compound 2-1
Compound 2-2

[Fig. 11]

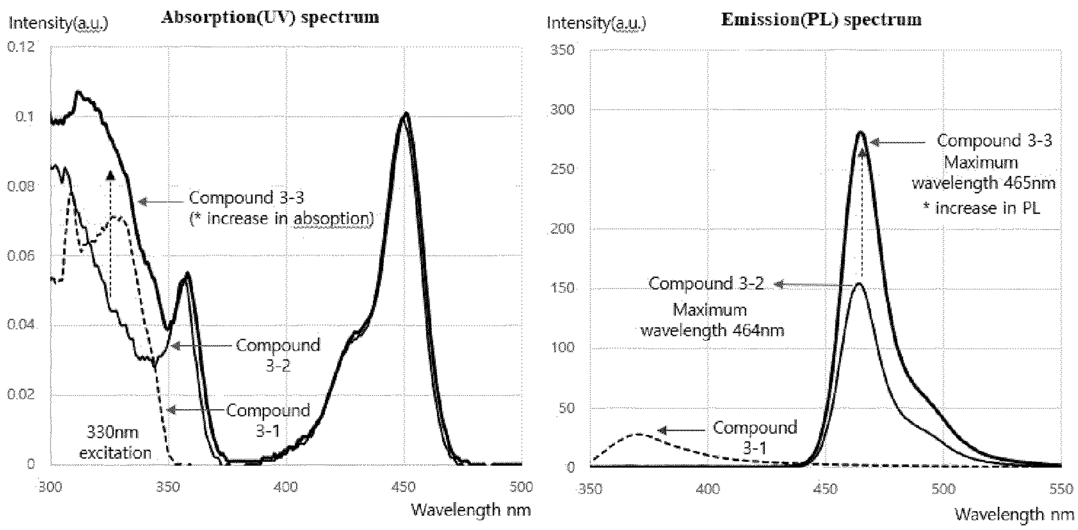
Intensity(a.u.)
Absorption(UV) spectrum
0.12
0.1
0.08
0.06
0.04
0.02
0
300
350
400
450
500
Wavelength nm
Compound 3-3
(* increase in absoption)
Compound
3-2
Compound
3-1
330nm
excitation
Intensity(a.u.)
Emission(PL) spectrum
350
300
250
200
150
100
50
0
350
400
450
500
550
Wavelength nm
Compound 3-3
Maximum
wavelength 465nm
* increase in PL
Compound 3-2
Maximum
wavelength 464nm
Compound
3-1

[Fig. 12]

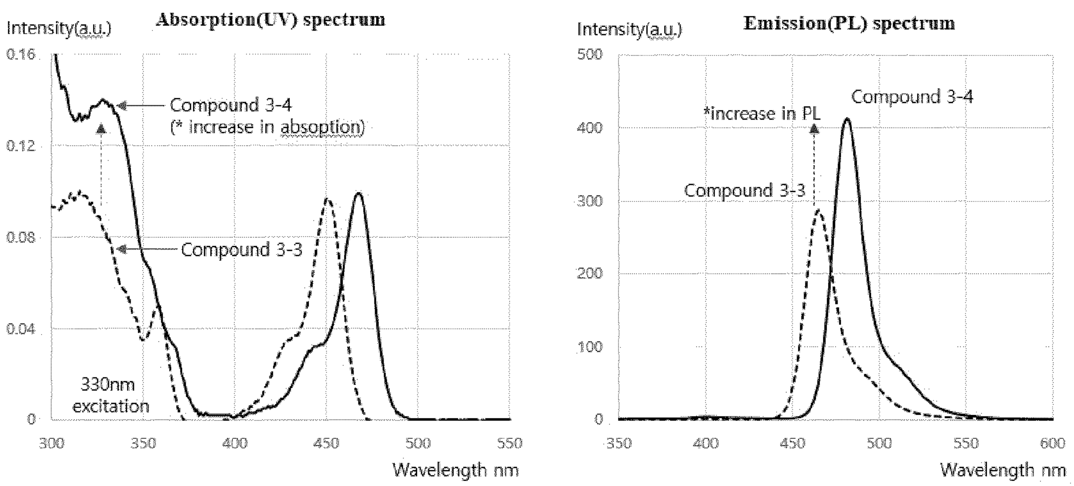
Intensity(a.u.)
Absorption(UV) spectrum
0.16
0.12
0.08
0.04
0
300
350
400
450
500
550
Wavelength nm
Compound 3-4
(* increase in absoption)
Compound 3-3
330nm
excitation
Intensity(a.u.)
Emission(PL) spectrum
500
400
300
200
100
0
350
400
450
500
550
600
Wavelength nm
Compound 3-4
*increase in PL
Compound 3-3

[Fig. 13]

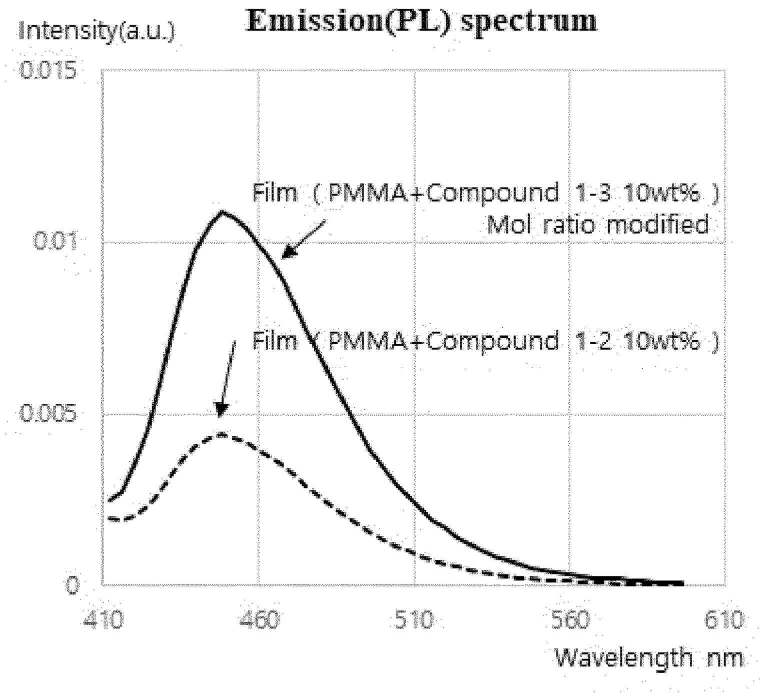
Intensity(a.u.)
Emission(PL) spectrum
0.015
0.01
0.005
0
410
460
510
560
610
Wavelength nm
Film ( PMMA+Compound 1-3 10wt% )
Mol ratio modified
Film ( PMMA+Compound 1-2 10wt% )

**INTERNATIONAL SEARCH REPORT**

International application No. **PCT/KR2022/009856**

**A. CLASSIFICATION OF SUBJECT MATTER**

**H01L 51/00**(2006.01)i; **H01L 51/50**(2006.01)i

According to International Patent Classification (IPC) or to both national classification and IPC

**B. FIELDS SEARCHED**

Minimum documentation searched (classification system followed by classification symbols)

H01L 51/00(2006.01); C07C 211/61(2006.01); C07D 209/86(2006.01); C09K 11/06(2006.01); H01L 27/32(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 에너지 다운 컨버전 시스템(energy down conversion system), 발광 모이어티 (luminescent moiety), 수광 모이어티(light receiving moiety), HOMO/LUMO

**C. DOCUMENTS CONSIDERED TO BE RELEVANT**

| Category* | Citation of document, with indication, where appropriate, of the relevant passages | Relevant to claim No. |
|---|---|---|
| A | US 2021-0062078 A1 (IDEMITSU KOSAN CO., LTD.) 04 March 2021 (2021-03-04)<br>See paragraphs [0006] and [0321]; and claim 1. | 1-22 |
| A | CN 110950763 A (SUZHOU JIUXIAN NEW MATERIAL CO., LTD.) 03 April 2020 (2020-04-03)<br>See entire document. | 1-22 |
| A | KR 10-2020-0122117 A (LG DISPLAY CO., LTD. et al.) 27 October 2020 (2020-10-27)<br>See entire document. | 1-22 |
| A | KR 10-2018-0021100 A (SICHUAN KNOWLEDGE EXPRESS INSTITUTE FOR INNOVATIVE TECHNOLOGIES CO., LTD.) 28 February 2018 (2018-02-28)<br>See entire document. | 1-22 |
| A | FINDLAY, Neil J. et al. An Organic Down-Converting Material for White-Light Emission from Hybrid LEDs. Advanced Materials. 2014, vol. 26, pp. 7290-7294.<br>See entire document. | 1-22 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 October 2022** | **13 October 2022** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**
**Information on patent family members**

International application No.
**PCT/KR2022/009856**

| Patent document cited in search report | Publication date (day/month/year) | Patent family member(s) | Publication date (day/month/year) |
|---|---|---|---|
| US 2021-0062078 A1 | 04 March 2021 | WO 2019-132040 A1 | 04 July 2019 |
| CN 110950763 A | 03 April 2020 | None | |
| KR 10-2020-0122117 A | 27 October 2020 | CN 111834535 A | 27 October 2020 |
| | | US 2020-0335705 A1 | 22 October 2020 |
| KR 10-2018-0021100 A | 28 February 2018 | CN 107849443 A | 27 March 2018 |
| | | CN 107849443 B | 21 April 2020 |
| | | JP 2018-532765 A | 08 November 2018 |
| | | JP 6674542 B2 | 01 April 2020 |
| | | KR 10-2096480 B1 | 03 April 2020 |
| | | US 11201291 B2 | 14 December 2021 |
| | | US 2018-0219159 A1 | 02 August 2018 |
| | | WO 2017-017205 A1 | 02 February 2017 |

Form PCT/ISA/210 (patent family annex) (July 2022)